(19) Europäisches Patentamt
European Patent Office
Office européen des brevets

(11) **EP 1 565 991 B1**

(12) **EUROPÄISCHE PATENTSCHRIFT**

(45) Veröffentlichungstag und Bekanntmachung des Hinweises auf die Patenterteilung:
**30.06.2010 Patentblatt 2010/26**

(21) Anmeldenummer: **03812126.5**

(22) Anmeldetag: **29.10.2003**

(51) Int Cl.:
***H03M 1/36*** *(2006.01)*

(86) Internationale Anmeldenummer:
**PCT/DE2003/003606**

(87) Internationale Veröffentlichungsnummer:
**WO 2004/051859 (17.06.2004 Gazette 2004/25)**

(54) **ANALOG-DIGITAL-WANDLER**

ANALOGUE-TO-DIGITAL CONVERTER

CONVERTISSEUR ANALOGIQUE-NUMERIQUE

(84) Benannte Vertragsstaaten:
**DE FR GB**

(30) Priorität: **29.11.2002 DE 10255915**

(43) Veröffentlichungstag der Anmeldung:
**24.08.2005 Patentblatt 2005/34**

(73) Patentinhaber: **Infineon Technologies AG**
**85579 Neubiberg (DE)**

(72) Erfinder: **PAULUS, Christian**
**82362 Weilheim (DE)**

(74) Vertreter: **Viering, Jentschura & Partner**
**Postfach 22 14 43**
**80504 München (DE)**

(56) Entgegenhaltungen:
**US-B1- 6 437 724**

- **PATENT ABSTRACTS OF JAPAN Bd. 1996, Nr. 02, 29. Februar 1996 (1996-02-29) & JP 7 254857 A (KAWASAKI STEEL CORP), 3. Oktober 1995 (1995-10-03) in der Anmeldung erwähnt**
- **GRAEME ET AL: "Operational Amplifiers/Design and Amplications" 1971, MCGRAW-HILL INTERNATIONAL , NEW-YORK * page 358 - page 369 ***

**Beschreibung**

Die Erfindung betrifft einen Analog-Digital-Wandler.

Ein Analog-Digital-Wandler (ADC) ist eine elektronische Schaltung beziehungsweise ein elektronischer Baustein, der ein analoges Signal in ein digitales Äquivalent umwandelt. Ein ADC setzt einen wertkontinuierlichen Spannungswert in eine Binärzahl um, die angibt, wie oft ein bestimmtes Spannungsintervall innerhalb des Spannungswertes enthalten ist.

Analog-Digital-Wandler (ADCs) werden an Schnittstellen zwischen analogen Signalen und digitaler Datenverarbeitung eingesetzt. Wesentliche Leistungsmerkmale eines ADCs sind die erreichbare Auflösung des Wandlers (gemessen in Bit) sowie die Umwandlungsgeschwindigkeit (gemessen in Samples pro Sekunde: Sa/s). Insbesondere im Bereich der Kommunikationstechnik besteht ein Bedarf an sehr schnellen Wandlern, d.h. Wandler mit hohen Umwandlungsraten (z.B.: >1 GSa/s). Die Auflösung bekannter Wandler liegt üblicherweise zwischen 5 Bit und 8 Bit, und die Schaltungsarchitektur entspricht einer Flash-Wandler-Architektur.

XP007901015 offenbart ein Flash-Wandler-Architektur.

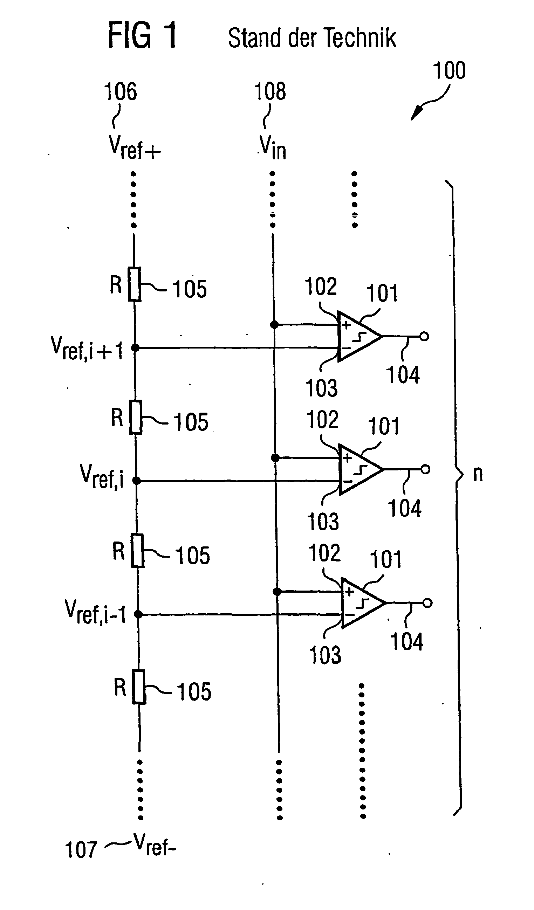

In **Fig.1** ist ein aus dem Stand der Technik bekannter Analog-Digital-Wandler 100 dargestellt.

Der Analog-Digital-Wandler 100 weist eine Vielzahl von Komparatoren 101 auf, die jeweils einen ersten Eingang 102, einen zweiten Eingang 103 und einen Ausgang 104 aufweisen. An dem ersten Eingang 102 eines jeden Komparators ist ein zu digitalisierendes Signal 108 $V_{in}$ in Form eines elektrischen Spannungssignals bereitgestellt. Zwischen einem jeweiligen zweiten Eingang 103 eines Komparators 101 und einem positiven Referenzpotential 106 $V_{ref+}$ bzw. einem negativen Referenzpotential $V_{ref-}$ ist eine für jeden der Komparatoren charakteristische Anzahl von ohmschen Widerständen 105 geschaltet. Beispielsweise ist zwischen dem zweiten Eingang 103 des gemäß Fig.1 obersten Komparators 101 und dem positiven Referenzpotential 106 ein einziger Widerstand 105 geschaltet, zwischen dem zweiten Eingang 103 des gemäß Fig.1 zweit obersten Komparators 101 und dem positiven Referenzpotential 106 $V_{ref+}$ sind zwei ohmsche Widerstände 105 geschaltet, usw. Anschaulich wird mittels des Spannungsabfalls an den zwischen dem Referenzpotential 106, 107 und dem zweiten Eingang 103 eines jeweiligen Komparators 101 geschalteten ohmschen Widerständen 105 das an dem zweiten Eingang 103 anliegende Potential gemäß Fig.1 von oben nach unten stufenweise verringert, so dass ein Vergleichsergebnis an den Ausgängen der Komparatoren 101 eine Abfolge von Ausgabewerten mit dem logischen Wert "1" und nachfolgend eine Abfolge von Ausgabewerten mit dem logischen Wert "0" liefert. Dieses digitalisierte Ausgabesignal wird als Thermometercode bezeichnet, wobei die Anzahl der Komparatorausgänge 104, an denen ein logischer Wert "1" anliegt, ein digitalisiertes Maß für den Wert des zu digitalisierten Signals 108 darstellt.

Bei der in Fig.1 gezeigten Schaltung eines Analog-Digital-Wandlers 100 gemäß dem Stand der Technik vergleichen die n Komparatoren 101 die Eingangsspannung $V_{in}$ 108 mit Referenzspannungen $V_{ref,i}$, die mittels des Widerstandsnetzwerkes aus Widerständen 105 generiert werden. Das Widerstandsnetzwerk ist üblicherweise als linearer Spannungsteiler ausgeführt, über welchen eine Referenzspannung $V_{ref+}$ bzw. $V_{ref-}$ angelegt wird. Mittels Verwendens gleicher Widerstände 105 wird die Referenzspannung $V_{ref} = V_{ref+} - V_{ref-}$ gleichmäßig auf die Komparatoren verteilt.

Bekannte Schaltungskonzepte für Analog-Digital-Wandler basieren auf dem sogenannten Flash-Verfahren. Hierbei wird die zu digitalisierende Eingangsspannung $V_{in}$ 108 simultan in die ersten Eingänge 102 der Komparatoren 101 angelegt. Um eine Auflösung von n Bit zu erreichen, sind $2^n - 1$ Komparatoren 101 erforderlich. An dem zweiten Eingang 103 der Komparatoren 101 sind jeweils unterschiedliche Teilspannungen angelegt, die mittels eines integrierten Referenzwiderstandsnetzwerks aus den Widerständen 105 erzeugt werden. Die Genauigkeit bzw. die Auflösung des Analog-Digital-Wandlers 100 wird im Wesentlichen von der Genauigkeit des Referenzwiderstandnetzwerkes und durch den Offset der Komparatoren 101 bestimmt. Diese Faktoren werden durch statistische Variationen von Bauteilparametern bestimmt, die mit zunehmender Fläche der Bauteile abnehmen.

Die Umwandlungsgeschwindigkeit eines A/D-Wandlers 100 wird vorrangig von der Architektur und der Geschwindigkeit der Komparatoren 101 bestimmt. Häufig wird eine Abtast-Halte-Schaltung dem eigentlichen Wandlerblock vorgeschaltet, welche die Eingangsspannung zu einem bestimmten Zeitpunkt analog speichert und hält und dem Wandlerblock zur Verfügung stellt. Auch dies begrenzt die Umwandlungsgeschwindigkeit und/oder die Auflösung des Wandlers.

Der Analog-Digital-Wandler gemäß dem Stand der Technik weist eine verbesserungsbedürftige Umwandlungsgeschwindigkeit auf.

Bauartbedingt weist ein Komparator ein definiertes Spannungsfenster auf, innerhalb welchem er optimal funktioniert, d.h., das Vergleichsergebnis seiner zwei analogen Eingansspannungen in ausreichend kurzer Zeit und mit ausreichender Genauigkeit am Ausgang 104 in digitaler Form bereitstellt. Die Signallaufzeit in einem Komparator 101 hängt jedoch stets von der Eingansspannung des Komparators 101 ab. Es gibt eine optimale Eingangsspannung, bei der das Vergleichsergebnis in vergleichsweise kurzer Zeit vorliegt. Nähert sich die Eingangsspannung den Grenzen des Spannungsfensters, nimmt die Laufzeit in einem Komparator zu und die Umwandlungsgeschwindigkeit wird reduziert.

Bei dem Analog-Digital-Wandler 100 gemäß dem Stand der Technik arbeitet jeder der Komparatoren 101 bei einer anderen Eingangsspannung. Daher müssen die Komparatoren 101 für einen weiten Eingangsspannungsbereich ausgelegt sein.

Somit liegt bei der beschriebenen Flash-Architektur gemäß dem Stand der Technik prinzipbedingt an jedem Komparator eine andere Eingangsspannung an, so dass jeder Komparator eine andere Signallaufzeit aufweist.

Zur Verarbeitung differentieller Signale in einem Analog-Digital-Wandler werden gemäß dem Stand der Technik die beiden zueinander gegenphasigen Eingangssignale jeweils von unabhängigen Komparatoren in ein digitales Signal gewandelt und anschließend digital subtrahiert. Selten werden auch aufwändige Komparatoren mit vier Eingängen verwendet.

[1] offenbart einen Analog-Digital-Wandler mit einer ersten Widerstandsleiter zwischen einer ersten Referenzspannung und einer zweiten Referenzspannung sowie mit einer zweiten Widerstandsleiter, dessen beide Endschnitte mit einer Analogsignalquelle gekoppelt sind.

[2] offenbart einen Analog-Digital-Wandler mit einer Mehrzahl von Verstärkern, deren Eingänge mit einem Analog-Signal über eine Widerstandskette versorgt werden.

[3] offenbart einen Analog-Digital-Wandler, bei dem der Einfluss eines Offsets reduziert werden soll und der A/D-Umwandlung ausreichend schnell und genau durchführen soll.

[4] offenbart einen Analog-Digital-Wandler mit zwei Netzwerken von Widerstandselementen, an die Analog-Signale angelegt werden und die mit Eingängen von Komparatoren gekoppelt werden.

[5] offenbart einen Analog-Digital-Wandler, mit dem ein Komparator-Offset kompensiert werden kann.

Der Erfindung liegt das Problem zugrunde, einen Analog-Digital-Wandler anzugeben, der gegenüber dem Stand der Technik eine erhöhte Umwandlungsgeschwindigkeit aufweist.

Das Problem wird durch einen Analog-Digital-Wandler mit dem Merkmalen gemäß dem unabhängigen Patentanspruch gelöst.

Der erfindungsgemäße Analog-Digital-Wandler zum Umwandeln eines zu digitalisierendes Signal in ein digitalisiertes Signal weist eine Mehrzahl von Komparatoren auf, von denen jeder einen ersten und einen zweiten Eingang und einen Ausgang aufweist, an welchem Ausgang das digitalisierte Signal bereitstellbar ist. Ferner enthält der erfindungsgemäße Analog-Digital-Wandler ein Impedanznetzwerk für jeden Komparator, das mit zumindest einem. Eingang des Komparators gekoppelt ist, wobei ein jeweiliges Impedanznetzwerk zwischen den zugehörigen Komparator und das zu digitalisierende Signal geschaltet ist und zwischen den zugehörigen Komparator und ein erstes elektrisches Referenzpotential geschaltet ist. Die Impedanznetzwerke sind derart eingerichtet, dass die Komparatoren in der Nähe ihrer spezifischen Entscheidungsschwelle im Wesentlichen auf den selben Arbeitspunkt gebracht sind.

"In der Nähe der spezifischen Entscheidungsschwelle" kann insbesondere bedeuten, dass der Betriebszustand eines Komparators innerhalb eines vorgegebenen Toleranzbereichs um die Entscheidungsschwelle herum gewählt ist bzw. einstellbar ist.

Eine Grundidee der Erfindung liegt darin, mittels eines eingangsseitigen Widerstandsnetzwerkes die Eingangsspannungen der Komparatoren des Analog-Digital-Wandlers auf nahezu denselben Spannungswert zu verschieben, d.h. die Komparatoren auf demselben Arbeitspunkt zu betreiben. Dadurch sind die im Stand der Technik auftretenden Probleme mit stark unterschiedlichen Signallaufzeiten in den Komparatoren eines Analog-Digital-Wandlers erheblich verringert.

Der erfindungsgemäße Analog-Digital-Wandler verschiebt anschaulich mittels eines Widerstandsnetzwerkes am Wandlereingang die Eingangsspannungen der Komparatoren derart, dass alle Komparatoren auf einem annähernd gleichen Arbeitspunkt betrieben werden können. Somit kann der Komparator auf diesen Arbeitspunkt optimiert werden, so dass der Analog-Digital-Wandler eine erhöhte Umwandlungsgeschwindigkeit aufweist. Aufgrund der auf diese Weise erreichten Synchronisation der Komparatorergebnisse ist zudem eine im Stand der Technik häufig erforderliche Abtast-Halte-Schaltung entbehrlich, wodurch die Leistungsfähigkeit des Analog-Digital-Wandlers zusätzlich verbessert bzw. der Herstellungsaufwand verringert ist.

Anders ausgedrückt ersetzt das erfindungsgemäß zwischen das zu digitalisierende Signal und die Komparatoren geschaltete Widerstandsnetzwerk am Eingang des Wandlers das zum Erzeugen von Referenzspannungen bei bekannten Flash-Wandlern erforderliche Widerstandsnetzwerk zwischen Referenzspannung und Komparatoren. Es kann erfindungsgemäß auf eine stark vereinfachte Komparatorenarchitektur zurückgegriffen werden, was die Umwandlungsgeschwindigkeit des Wandlers zusätzlich verbessert und das Schaltungsdesign in modernen CMOS-Prozessen mit niedrigen Betriebsspannungen erleichtert. Aufgrund der annähernd identischen Eingangsspannungen der Komparatoren sind auch Kalibrier-Techniken ("Autozeroing"-Techniken) zur Reduktion von beispielsweise herstellungsbedingten Offsets der Komparatoren leicht implementierbar.

Ferner ist mit der erfindungsgemäßen Schaltungsarchitektur für den Analog-Digital-Wandler ein echter Rail-to-Rail-Betrieb des Analog-Digital-Wandlers ermöglicht. D.h., dass die analoge Eingangsspannung des Wandlers zwischen einer oberen Betriebsspannungsgrenze und einer unteren Betriebsspannungsgrenze liegen kann. Bei geeigneter Dimensionierung des Impedanznetzwerks kann die Eingangsspannung die Betriebsspannungsgrenzen sogar über-/unterschreiten.

Bei aus dem Stand der Technik bekannten CMOS-Analog-Digital-Wandlern ist oftmals ein gegen unendlich strebender ohmscher Eingangswiderstand gegeben, so dass eine rein kapazitive Eingangsimpedanz vorgesehen ist. Im Gegensatz dazu hat der Eingang des erfindungsgemäßen Analog-Digital-Wandlers aufgrund des Einsatzes eines eingangseitigen Widerstandsnetzwerkes eine Eingangsimpedanz mit ohmschem Anteil. Insbesondere bei Wandlern mit hohen Umwandlungsraten und folglich zumeist hohen Eingangsfrequenzen kann der ohmsche Anteil der Eingangsimpedanz sogar einen Vorteil darstellen. Bei hohen Eingangsfrequenzen ist üblicherweise ohnehin ein Abschlusswiderstand einer als Wellenleiter ausgeführten Eingangsleitung notwendig, um Signalreflexionen zu vermeiden. Die kapazitive Last müsste ohnehin von der Quelle getrieben werden und die kapazitive Last weist bei hohen Eingangsfrequenzen die gleiche Größenordnung auf wie die ohmsche Last. Mit der erfindungsgemäßen Analog-Digital-Wandler-Architektur ist der Abschlusswiderstand in Form des Eingangswiderstandes des Analog-Digital-Wandlers bereits vorhanden.

Bevorzugte Weiterbildungen der Erfindung ergeben sich aus den abhängigen Ansprüchen.

Der zweite Eingang von zumindest einem Teil der Komparatoren, vorzugsweise von allen Komparatoren, des erfindungsgemäßen Analog-Digital-Wandlers, kann auf ein zweites elektrisches Referenzpotential gebracht sein. Das zweite elektrische Referenzpotential kann beispielsweise das Massepotential sein.

Zumindest ein Teil der Impedanznetzwerke der Komparatoren des Analog-Digital-Wandlers kann einen ersten ohmschen Widerstand und einen zweiten ohmschen Widerstand aufweisen, wobei der erste ohmsche Widerstand zwischen den ersten Eingang von zumindest einem Teil der Komparatoren und das erste elektrische Referenzpotential geschaltet ist. Der zweite ohmsche Widerstand kann zwischen den ersten Eingang von zumindest einem Teil der Komparatoren und das zu digitalisierende Signal geschaltet sein.

Zumindest ein Teil der Impedanznetzwerke kann einen Spannungsteiler aufweisen. Der Spannungsteiler kann eine erste Impedanz aufweisen oder von ihr gebildet sein, die zwischen dem ersten Eingang und ein drittes elektrisches Referenzpotential geschaltet ist. Zusätzlich kann der Spannungsteiler eine zweite Impedanz aufweisen oder von ihr gebildet sein, die zwischen dem ersten Eingang und das erste elektrische Referenzpotential geschaltet ist. Die erste Impedanz kann ein dritter ohmscher Widerstand sein und/oder die zweite Impedanz kann ein vierter ohmscher Widerstand sein. Jeder der ohmschen Widerstände kann zum Beispiel unter Verwendung einer oder mehrerer ohmscher Einzelwiderstände realisiert sein. Alternativ kann die erste Impedanz eine erste Kapazität und/oder die zweite Impedanz eine zweite Kapazität sein. Mit anderen Worten kann der Spannungsteiler wahlweise eine kapazitive und/oder eine ohmsche Komponente aufweisen. Jede der Kapazitäten kann zum Beispiel unter Verwendung einer oder mehrerer Kondensatoren realisiert sein.

Das dritte elektrische Referenzpotential kann das elektrischen Massepotential sein. Somit kann das Potential an der ersten Impedanz des Spannungswandlers identisch ausgeführt sein wie das elektrische Potential an den zweiten Eingängen der Komparatoren, so dass die Zahl der erforderlichen Referenzpotentiale gering gehalten ist.

Das erste elektrische Referenzpotential kann in ein erstes Teilpotential und in ein zweites Teilpotential aufgeteilt sein, wobei für einen ersten Teil der Komparatoren deren Impedanznetzwerk zwischen den ersten Eingang und das erste Teilpotential geschaltet ist, und wobei für einen zweiten Teil, vorzugsweise den restlichen Teil, der Komparatoren deren Impedanznetzwerk zwischen den ersten Eingang und das zweite Teilpotential geschaltet ist. Beispielsweise kann die erste Hälfte von Komparatoren des erfindungsgemäßen Analog-Digital-Wandlers an ein positives Referenzpotential als erstes Teilpotential angeschlossen sein, wohingegen der zweite Teil der Komparatoren (z.B. die zweite Hälfte der Komparatoren) an ein negatives zweites Teilpotential angeschlossen sein kann. Bei einer_ungeradzahligen Anzahl von n Komparatoren können $(n-1)/2$ Komparatoren an das positive Referenzpotential angeschlossen sein, $(n-1)/2$ andere Komparatoren können an das negative Referenzpotential angeschlossen sein, und ein Komparator kann an das positive oder an das negative oder an ein anderes Referenzpotential angeschlossen sein.

Vorzugsweise weisen das zweite und/oder das dritte elektrische Referenzpotential einen Wert zwischen dem ersten und dem zweiten Teilpotential auf, vorzugsweise ist ihr Potential das arithmetische Mittel aus dem ersten und dem zweiten Teilpotential. Somit können das zweite und/oder das dritte elektrische Referenzpotential das elektrische Massepotential sein, das erste Teilpotential ein gegenüber dem Massepotential um einen vorgegebenen Wert erhöhtes Potential und das zweite Teilpotential ein um diesen Wert verringertes Potential sein.

Für zumindest einen Teil der Komparatoren kann eine Kalibrier-Einrichtung vorgesehen sein, die derart eingerichtet ist, dass mit dieser eine Parameterschwankung zwischen unterschiedlichen Komparatoren korrigierbar ist.

Herstellungsbedingt können die Komparatoren des Analog-Digital-Wandlers einen unterschiedlichen Offset-Wert aufweisen, welche Schwankung die Funktionalität des Analog-Digital-Wandlers beeinträchtigen kann. Mittels der Kalibrier-Einrichtung kann diese Schwankung kompensiert werden, so dass eine reibungslose Funktionalität des Analog-Digital-Wandlers ermöglicht ist.

Beispielsweise kann die Kalibrier-Einrichtung ein Schaltelement (realisierbar z.B. als Transistorschalter) zwischen dem ersten Eingang eines Komparators und dem Impedanznetzwerk aufweisen, mittels welchen Schaltelements in einem Erfassmodus der erste Eingang des Komparators mit dem Impedanznetzwerk koppelbar ist. Alternativ kann in einem Kalibriermodus der erste Eingang auf ein viertes elektrisches Referenzpotential gebracht werden, wobei basierend auf einem in diesem Betriebszustand resultierenden Signal am Ausgang des Komparators der Komparator mittels der Kalibrier-Einrichtung kalibriert wird.

Das vierte elektrische Referenzpotential kann gleich dem zweiten elektrischen Referenzpotential sein und kann insbesondere gleich dem Massepotential sein. Anschaulich können der erste Eingang und der zweite Eingang in dem Kalibriermodus auf das gleiche elektrische Potential gebracht werden und basierend auf dem resultierenden Ausgangssignal ein möglicher Offset des zugehörigen Komparators eliminiert oder verringert werden.

Der Wert von zumindest einem der ersten bis vierten ohmschen Widerstände von zumindest einem Teil der Impedanznetzwerke kann basierend auf dem Kriterium berechnet werden, dass an einem der ersten Eingänge der Komparatoren ein Signal anliegt, das im Wesentlichen gleich dem zweiten elektrischen Referenzpotential ist. Dieser spezielle Komparator stellt anschaulich diejenige Stelle in der Anordnung von Komparatoren dar, an der die Ausgänge der Komparatoren von einem logischen Wert "1" auf einen logischen Wert "0" (bzw. umgekehrt) übergehen.

Der Wert der ersten bis vierten ohmschen Widerstände kann zumindest für einen Teil der Impedanznetzwerke zusätzlich oder alternativ basierend auf dem Kriterium berechnet werden, dass eine Veränderung des zu digitalisierenden Signals um einen vorgebbaren Wert für zumindest einen Teil der Komparatoren zu einer Veränderung des elektrischen Potentials an deren ersten Eingang um einen im Wesentlichen gleichen Wert führt.

Anschaulich werden die Werte der Widerstände derart gewählt, dass die Empfindlichkeit der Komparatorspannung auf die Eingangsspannung für alle Komparatoren im Wesentlichen gleich ist.

Ferner kann der Wert von zumindest einem der ersten bis vierten ohmschen Widerstände für zumindest einen Teil der Impedanznetzwerke basierend auf dem Kriterium berechnet werden, dass der ohmsche Ausgangswiderstand von zumindest einem Teil der Impedanznetzwerke im Wesentlichen gleich ist.

Gemäß einem bevorzugten Ausführungsbeispiel können basierend auf allen drei der zuvor beschriebenen Kriterien optimierte Werte der ohmschen Widerstände der Impedanznetzwerke des erfindungsgemäßen Analog-Digital-Wandlers berechnet werden.

Ferner kann bei dem erfindungsgemäßen Analog-Digital-Wandler für zumindest einen Teil der Komparatoren das Impedanznetzwerk eine mit dem ersten Eingang gekoppelte erste Impedanz-Teileinrichtung und eine mit dem zweiten Eingang gekoppelte Impedanz-Teileinrichtung aufweisen. Darüber hinaus kann das zu digitalisierende Signal in ein erstes und in ein zweites zu digitalisierendes Teilsignal aufgeteilt sein. Das erste elektrische Referenzpotential kann in ein erstes Teilpotential und in ein zweites Teilpotential aufgeteilt sein. Die Impedanz-Teileinrichtung kann zwischen den ersten Eingang, das erste zu digitalisierende Teilsignal und das erste Teilpotential geschaltet sein. Die zweite Impedanz-Teileinrichtung kann zwischen den zweiten Eingang, das zweite zu digitalisierende Teilsignal und das zweite Teilpotential geschaltet sein.

Das erste und das zweite zu digitalisierende Teilsignal können differenzielle Signale sein.

Mit anderen Worten kann der erfindungsgemäße Analog-Digital-Wandler insbesondere auch auf solche Schaltungsarchitekturen angepasst sein, bei denen ein zu digitalisierendes Eingabesignal in zweifacher Form, d.h. in Form zweier komplementärer Signale, bereitgestellt ist. In einem solchen Fall ist an dem ersten Eingang des Komparators eines der beiden mittels des Impedanznetzwerks modifizierten differenziellen, zu digitalisierenden Signale angelegt, an den zweiten Eingang das andere der beiden differenziellen, zu digitalisierenden Signale, wiederum modifiziert mittels des Impedanznetzwerks.

Bei dem erfindungsgemäßen Analog-Digital-Wandler kann die erste Impedanz-Teileinrichtung einen ersten ohmschen Widerstand und einen zweiten ohmschen Widerstand aufweisen, wobei der erste ohmsche Widerstand zwischen den ersten Eingang und das erste elektrische Teilpotential geschaltet ist, wobei der zweite ohmsche Widerstand zwischen den ersten Eingang und das erste zu digitalisierende Teilsignal geschaltet ist. Ferner kann die zweite Impedanz-Teileinrichtung einen dritten ohmschen Widerstand und einen vierten ohmschen Widerstand aufweisen, wobei der dritte ohmsche Widerstand zwischen den zweiten Eingang und das zweite elektrische Teilpotential geschaltet ist, und wobei der vierte ohmsche Widerstand zwischen den zweiten Eingang und das zweite zu digitalisierende Teilsignal geschaltet ist. Anschaulich sind die beiden Signalpfade der differenziellen Signale spiegelbildlich zueinander aufgebaut.

Zwischen dem ersten und dem zweiten Eingang kann mindestens ein fünfter ohmscher Widerstand geschaltet sein. Der fünfte ohmsche Widerstand kann zum Beispiel ein einzelner Widerstand sein oder kann in zwei Teilwiderstände aufgeteilt sein.

Der fünfte ohmsche Widerstand kann in einen ersten und in einen zweiten Teilwiderstand aufgeteilt sein, wobei ein Anschluss zwischen dem ersten und dem zweiten Teilwiderstand auf ein fünftes elektrisches Referenzpotential, vorzugsweise das elektrische Massepotential gebracht sein kann. Gemäß dieser Ausgestaltung ist ein Mittelabgriff zwischen den beiden Teilwiderständen vorgesehen, der auf ein definiertes elektrisches Potential gebracht werden kann.

Der Analog-Digital-Wandler der Erfindung kann als integrierter Schaltkreis eingerichtet sein, insbesondere auf und/oder in einem Substrat, vorzugsweise einem Halbleitersubstrat (z.B. in Silizium-Technologie), integriert sein.

Ausführungsbeispiele der Erfindung sind in den Figuren dargestellt und werden im Weiteren näher erläutert.

Es zeigen:

Figur 1        einen Analog-Digital-Wandler gemäß dem Stand der Technik,

Figur 2        einen Analog-Digital-Wandler gemäß einem ersten Ausführungsbeispiel der Erfindung,

Figur        3 einen Analog-Digital-Wandler gemäß einem zweiten Ausführungsbeispiel der Erfindung,

Figur 4        einen Analog-Digital-Wandler gemäß einem dritten Ausführungsbeispiel der Erfindung,

Figur 5        einen Analog-Digital-Wandler gemäß einem vierten Ausführungsbeispiel der Erfindung,

Figur 6A        und 6B Tabellen für Widerstandswerte für den erfindungsgemäßen Analog-Digital-Wandler,

Figur 7        einen Analog-Digital-Wandler gemäß einem fünften Ausführungsbeispiel der Erfindung,

Figur 8        einen Analog-Digital-Wandler gemäß einem sechsten Ausführungsbeispiel der Erfindung.

Gleiche oder ähnliche Komponenten in unterschiedlichen Figuren sind mit gleichen Bezugziffern versehen.

Die Darstellungen in den Figuren sind schematisch und nicht maßstäblich.

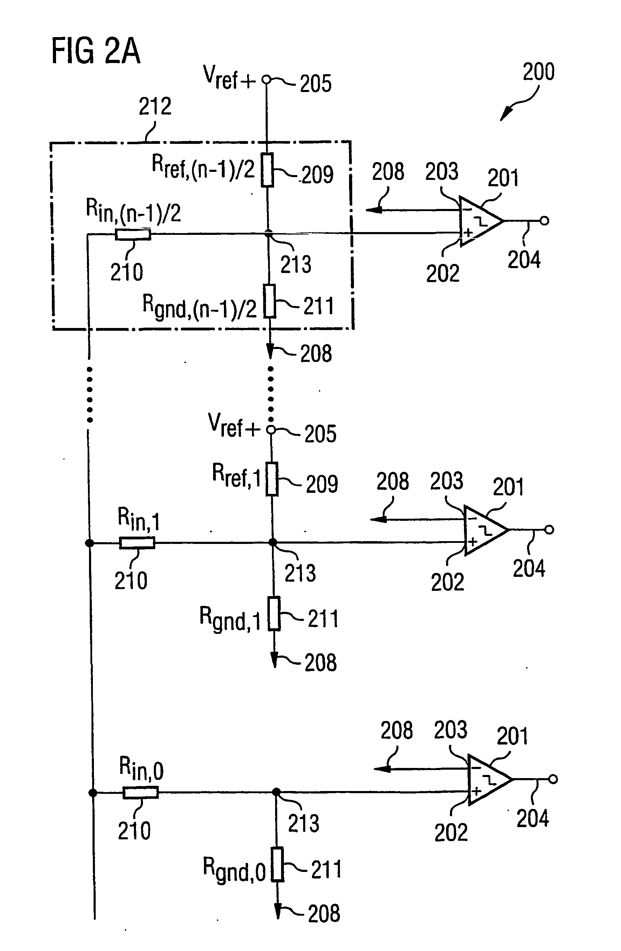

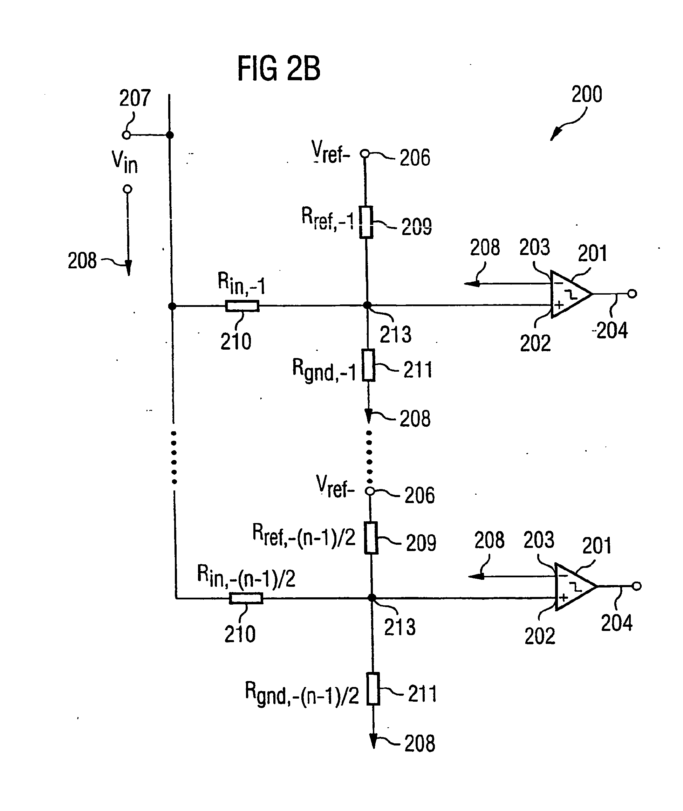

Im Weiteren wird bezugnehmend auf **Fig.2** ein Analog-Digital-Wandler 200 gemäß einem ersten Ausführungsbeispiel der Erfindung beschrieben.

Der Analog-Digital-Wandler 200 enthält eine Vielzahl von Komparatoren 201, von denen jeder einen ersten Eingang 202, einen zweiten Eingang 203 und einen Ausgang 204 aufweist. An dem Ausgang 204 von jedem der Komparatoren 201 ist 1 Bit eines Thermometercodes bereitgestellt, welcher das digitalisierte Signal darstellt. Anders ausgedrückt ist an jedem Ausgang 204 eines jeden Komparator 201 ein Signal mit einem ersten logischen Wert (z.B. logischer Wert "1") oder mit einem zweiten logischen Wert (z.B. logischer Wert "0") bereitgestellt, basierend darauf., welche elektrischen Potentiale an den. Eingängen 202, 203 des jeweiligen Komparators 201 angelegt sind. Ferner ist für jeden Komparator 201 ein Widerstandsnetzwerk 212 aus ersten bis dritten ohmschen Widerständen 209 bis 211 vorgesehen, das mit dem ersten Eingang 202 eines jeden Komparators 201 gekoppelt ist. Das dem jeweiligen Komparator 201 zugeordnete Widerstandsnetzwerk 212 ist zwischen den zugehörigen Komparator 201 und ein zu digitalisierendes Signal $V_{in}$ 207 geschaltet. Ferner ist das Widerstandsnetzwerk 212 zwischen einen zugehörigen Komparator 201 und ein zugehöriges elektrisches Referenzpotential $V_{ref+}$ 205 bzw. $V_{ref-}$ 206 geschaltet. Der Analog-Digital-Wandler 200 weist n Komparatoren 201 auf. Der gemäß Fig.2 obere Anteil von Komparatoren 201 weist als elektrisches Referenzpotential ein positives Referenzpotential $V_{ref+}$ auf, wohingegen der gemäß Fig.2 untere Anteil der Komparatoren 201 als elektrisches Referenzpotential ein negatives Referenzpotential 206 $V_{ref-}$ aufweist. Der zweite Eingang 203 der Komparatoren 201 ist jeweils auf das elektrische Massepotential 208 gebracht. Der erste ohmsche Widerstand 209 $R_{ref,i}$ ist zwischen das jeweilige Referenzpotential 205 bzw. 206 einerseits und den ersten Eingang 202 des zugehörigen Komparators 201 geschaltet. Der zweite ohmsche Widerstand $R_{in,i}$ eines jeweiligen Komparators 201 ist zwischen den ersten Eingang 202 des zugehörigen Komparators 201 und das zu digitalisierende Signal $V_{in}$ 207 geschaltet. Ferner ist ein dritter ohmscher Widerstand $R_{gnd,i}$ 211 zwischen den ersten Eingang 202 des zugehörigen Komparators 201 und das elektrische Massepotential 208 geschaltet.

Der Analog-Digital-Wandler 200 enthält n Komparatoren, wobei n vorzugsweise eine ungerade Zahl ist. Wie in Fig.2 gezeigt, ist an diejenigen ersten ohmschen Widerstände 209, die den gemäß Fig.2 oberen (n-1)/2 Komparatoren 201 zugeordnet sind, das elektrische Potential $V_{ref+}$ angelegt. An diejenigen ersten ohmschen Widerstände 209, die den gemäß Fig.2 unteren (n-1)/2 Komparatoren 201 zugeordnet sind, das elektrische Potential $V_{ref-}$ angelegt. Bei demjenigen Komparator 201, der zwischen den (n-1)/2 oberen und den (n-1)/2 unteren Komparatoren 201 angeordnet ist, nämlich bei dem Komparator 201 mit dem Index "0, ist ein erster ohmscher Widerstand 209 nicht vorgesehen. Anschaulich gesprochen könnte ein ohmscher Widerstand 209 auch für den Komparator 201 mit dem Index "0" vorgesehen sein, dieser würde dann einen gegen unendlich strebenden Wert des ohmschen Widerstands aufweisen.

Es ist anzumerken, das die Werte des ersten ohmschen Widerstands $R_{ref,i}$ 209 bei unterschiedlichen Komparatoren 201 unterschiedlich sein können. Analog können die Werte der zweiten bzw. dritten ohmschen Widerstände $R_{in,i}$ 210, $R_{gnd,i}$ 211 unterschiedlicher Komparatoren 201 unterschiedliche Werte aufweisen.

Im Weiteren wird die Funktionalität des Analog-Digital-Wandlers 200 beschrieben.

Die Eingangsspannung $V_{in}$ 207 wird mittels eines Widerstandsnetzwerks 212, das jedem Komparator 201 vorgeschaltet ist, derart verschoben, dass in der Nähe der spezifischen Entscheidungsschwelle des jeweiligen Komparators 201 eine Eingangspannung nahe dem elektrischen Massepotential 208 anliegt. Somit arbeiten alle Komparatoren 201 auf ähnlichen Arbeitspunkten und können somit auf die maximale Leistungsfähigkeit optimiert werden. Die ohmschen Widerstände 209 bis 211 haben die Funktion, das Eingangssignal $V_{in}$ 207 unter Verwendung der Referenzspannung $V_{ref}$ (die im weiteren als Oberbegriff für das positive Referenzpotential 205 $V_{ref+}$ und das negative Referenzpotential 206 $V_{ref-}$ verwendet wird) soweit zu verschieben, dass bei einer vorgegebenen Eingangsspannung $V_{in,i}$ 207 an einem ersten Eingang 202 eines jeweiligen Komparators 201 ein Potential nahe dem elektrischen Massepotential 208 anliegt. Der dritte ohmsche Widerstand $R_{gnd}$ 211 dient dazu, die Empfindlichkeit eines jeweiligen Komparators 201 bezüglich der Eingangsspannung $V_{in,i}$ 207 anzupassen.

Es gilt für den Eingangsknoten $V_{comp}$ 213 des i-ten Komparators 201:

$$\frac{V_{in} - V_{comp,i}}{R_{in,i}} - \frac{V_{comp,i}}{R_{gnd,i}} + \frac{V_{ref,\pm} - V_{comp,i}}{R_{ref,i}} = 0 \qquad\qquad (1)$$

Zum Verschieben der Eingangsspannung $V_{in}$ 207 auf Massenniveau 208 ist eine Referenzspannung $V_{ref,\pm}$ 205, 206 erforderlich. Diese Referenzspannung ist positiv ($V_{ref+}$), wenn eine negative Eingangsspannung $V_{in}$ 207 verarbeitet werden soll, und ist negativ ($V_{ref-}$) wenn eine positive Eingangsspannung $V_{in}$ 207 verarbeitet werden soll.

Gemäß dem beschriebenen Ausführungsbeispiel ist die erste Nebenbedingung für das Berechnen der Werte der ersten bis dritten Widerstände 209 bis 211, dass $V_{comp,i}=0$ für $V_{in,i}=i \cdot _{\Delta}V$ mit $i=-m, ..., 0, ..., +m$ ist, wobei $2m+1=n$ ist. Anschaulich bedeutet dies, dass die Eingangsspannung $V_{comp,i}$ am i-ten Komparator 201 exakt Null sein soll, wenn die Eingangsspannung 207 einen bestimmten Wert $V_{in,i}=i \cdot _{\Delta}V$ aufweist.

Dies wird durch Gleichung (2) ausgedrückt:

$$\frac{i \cdot \Delta V}{R_{in,i}} + \frac{V_{ref,\pm}}{R_{ref,i}} = 0 \qquad\qquad (2)$$

In Gleichung (2) bezeichnet $_{\Delta}V$ eine (ausreichend kleine) Spannungsdifferenz, die in dem Analog-Digital-Wandler 200 dem Least Significant Bit (LSB) entspricht und somit die Auflösung bestimmt.

Als zweite Nebenbedingung zum Berechnen der Werte der ohmschen Widerstände 209 bis 211 wird gefordert, dass die Empfindlichkeit der Komparatorspannung auf die Eingangsspannung für alle Komparatoren 201 gleich ist. Bei der Änderung der Eingangsspannung, um beispielsweise $_{\Delta}V_{in}$ soll sich die Eingabespannung an jedem Komparator 201 in der Nähe seiner Entscheidungsschwelle $V_{comp,i}=0$ um einen Wert $_{\Delta}V_{comp}$ ändern:

$$\frac{\partial V_{comp,i}}{\partial V_{in}} = \frac{1}{1 + \dfrac{R_{in,i}}{R_{ref,i}} + \dfrac{R_{in,i}}{R_{gnd,i}}} = const. \qquad \forall i \qquad\qquad (3)$$

Um den Einfluss von Parameterschwankungen gering zu halten, soll dieser Wert möglichst groß sein. Innerhalb der n Komparatoren 201 des Analog-Digital-Wandlers 200 weisen die beiden Komparatoren 201 mit $i=-m$ und $i=+m$ die niedrigste Empfindlichkeit auf.

Ferner lässt sich aus Überlegungen der Signaldynamik eine dritte Nebenbedingung für die Berechnung der Werte der ohmschen Widerstände 209 bis 211 formulieren. Da jeder Komparatoreingang eine Eingangskapazität aufweist, bildet sich in Kombination mit dem vorgeschalteten Widerstandsnetzwerk 212 anschaulich ein Tiefpass aus. Damit das Eingabesignal an jedem Komparator 201 eine im Wesentlichen gleiche Frequenzformung erfährt, sollte der Ausgangswiderstand $R_{out}$ des Widerstandsnetzwerkes 212 für alle Komparatoren 201 identisch sein:

$$\frac{1}{R_{in,i}} + \frac{1}{R_{ref,i}} + \frac{1}{R_{gnd,i}} = \frac{1}{R_{out}} = \text{const.} \qquad \forall i \qquad\qquad (4)$$

Die Berechnung der Widerstandswerte 209 bis 211 ist besonders einfach, wenn die positive Referenzspannung $V_{ref+}$ 205 bzw. die negative Referenzspannung $V_{ref-}$ den Grenzwerten der Eingangsspannung $V_{in}$ 207 entspricht, d.h. $V_{ref+}=m._\Delta V$ bzw. $V_{ref-}=-m._\Delta V$.

In diesen Falle folgt direkt aus Gleichung (2), dass $R_{in,m}=R_{ref,m}$ ist. Aus (3) folgt ferner:

$$\frac{\partial V_{comp,m}}{\partial V_{in}} = \frac{1}{1 + \frac{R_{in,m}}{R_{ref,m}} + \frac{R_{in,m}}{R_{gnd,m}}} = \frac{1}{2} \qquad \text{für } R_{gnd,m} \to \infty \qquad (5)$$

Dies bedeutet weiterhin für alle Komparatoren 201, dass gilt:

$$\frac{1}{R_{in,i}} = \frac{1}{R_{ref,i}} + \frac{1}{R_{gnd,i}} \qquad\qquad\qquad (6)$$

Somit folgt unter Verwendung von (4)

$$R_{in,i} = 2R_{out} = R_{in} = \text{const.} \qquad \forall i \qquad\qquad (7)$$

Der zweite Widerstand $R_{in}$ 210 aller Widerstandsnetzwerke 212 weist in diesem Fall denselben Wert auf.

Zum eindeutigen Berechnen aller Widerstandswerte 209 bis 211 ist es zweckmäßig, den Eingangswiderstand der gesamten Wandlers 200 zu bestimmen. Dieser betrage beispielsweise 50Ω, was in der Hochfrequenztechnik eine übliche Impedanz ist. Soll ein 6 Bit Analog-Digital-Wandler 200 realisiert werden, müssen mindestens 63 Komparatoren mit ihren jeweiligen Eingangswiderstandsnetzwerken 212 parallel geschaltet werden. Zur einfachen Berechnung wird im Folgenden angenommen, dass 64 Widerstandsnetzwerke 212 parallel geschaltet sind. In diesem Fall ist der Eingangswiderstand eines einzelnen Netzwerkes 3200Ω, und es folgt aus $R_{in,m}=R_{ref,m}$, dass $R_{in}=R_{ref,m}=1600Ω$. Der Wert von $R_{ref,i}$ kann aus Gleichung (2) berechnet werden, der Wert $R_{gnd,i}$ kann aus Gleichung (5) berechnet werden.

Somit sind alle Widerstände 209 bis 211 eindeutig bestimmt und das erfindungsgemäße Widerstandsnetzwerk 212 wird die Eingangsspannung des Analog-Digital-Wandlers 200 für jeden Komparator 201 derart aufbereitet, dass alle Komparatoren 201 stets auf einem optimalen Betriebspunkt betrieben werden.

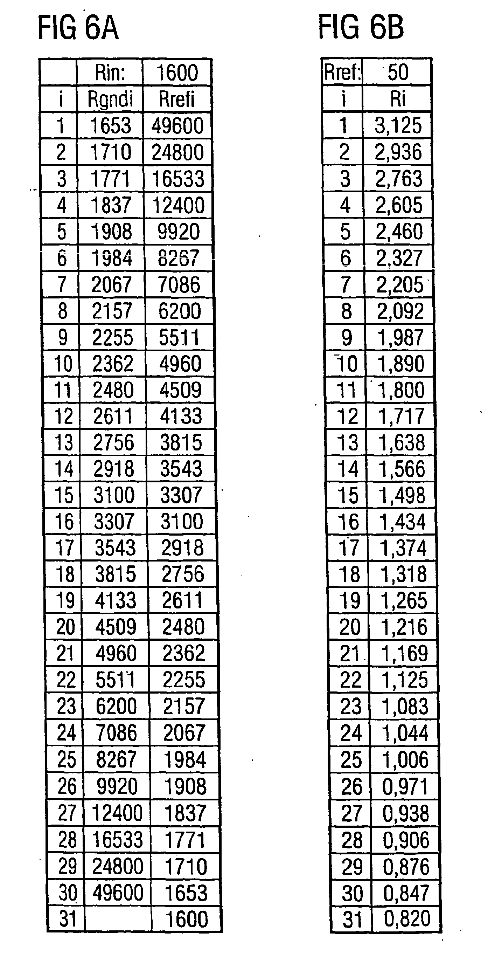

In **Fig.6A** sind die Widerstandswerte 209 bis 211 für einen 6 Bit Wandler mit einer Eingansimpedanz von 50Ω und für in das Fig.2 gezeigte Ausführungsbeispiel dargestellt (in Ω).

Es ist anzumerken, dass die dritten ohmschen Widerstände $R_{gnd,i}$ 211 optional sind und auch weggelassen werden können, um eine noch weniger aufwändig herzustellende Analog-Digital-Wandler zu erhalten. Bei Verwendung der dritten ohmschen Widerstände $R_{gnd}$ 211 ist jedoch sichergestellt, dass die Komparatoren 201 bei annähernd der gleichen Empfindlichkeit betrieben werden, was zu einer erhöhten effektiven Auflösung des Wandlers 200 führt.

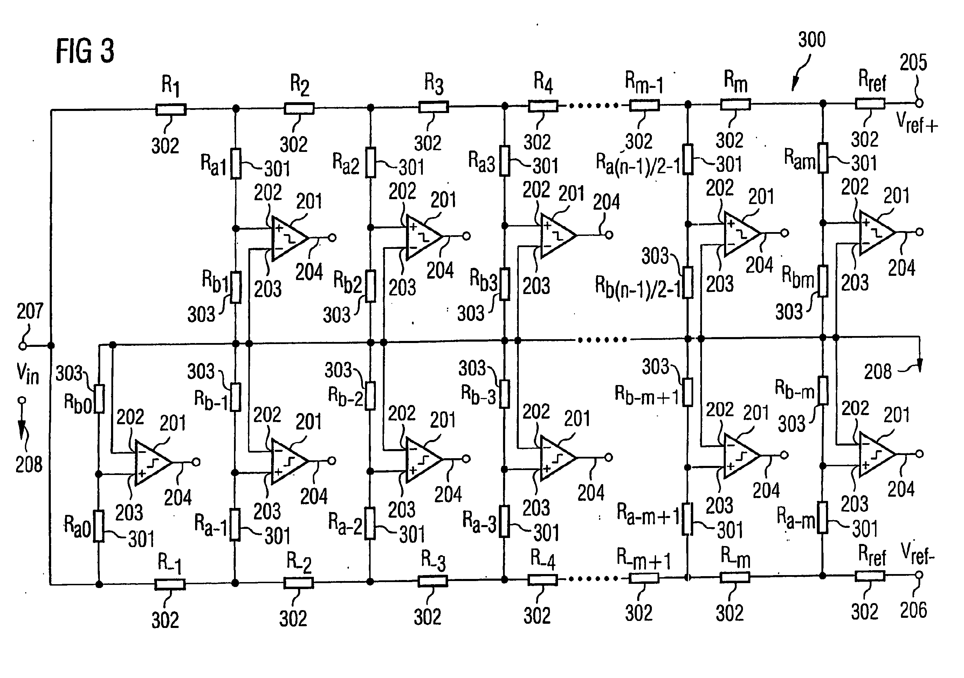

Im Weiteren wird bezugnehmend auf **Fig.3** ein Analog-Digital-Wandler 300 gemäß einem zweiten Ausführungsbeispiel der Erfindung beschrieben.

Der Analog-Digital-Wandler 300 unterscheidet sich von dem Analog-Digital-Wandler 200 im Wesentlichen durch die modifizierte Verschaltung von ohmschen Widerständen der Widerstandsnetzwerke. Der Analog-Digital-Wandler 300 weist wiederum erste ohmsche Widerstände 301, zweite ohmsche Widerstände 302 und dritte ohmsche Widerstände 303 auf. Die dritten ohmschen Widerstände 303 haben gemäß Fig.3 im Wesentlichen dieselbe Funktion wie die dritten ohmschen Widerstände 211 in Fig.2. Dagegen ist die Funktionalität der ersten und zweiten ohmschen Widerstände 301, 302 des Analog-Digital-Wandlers 300 mit der Funktionalität der ersten und zweiten Widerstände 209, 210 aus Fig. 2 nicht identisch.

Betrachtet man beispielsweise den gemäß Fig.3 linken oberen Komparator 201, so ist dessen zweiter Eingang 203 wiederum geerdet, d.h. auf das elektrische Massepotential 208 gebracht. Zwischen den ersten Eingang 202 des betrachteten Komparators 201 und das Massepotential 208 ist ein dritter ohmscher Widerstand $R_{b1}$ 303 geschaltet. Ferner ist zwischen dem ersten Eingang 202 und das zu digitalisierende Signal $V_{in}$ 207 ein ohmscher Gesamtwiderstand geschaltet, der sich aus dem ersten ohmschen Widerstand 301 $R_{a1}$ und dem zweiten ohmschen Widerstand $R_1$ 302 zusammensetzt. Anschaulich bilden die Widerstände $R_{a1}$ und $R_1$ einen effektiven Gesamtwiderstand, welcher mit dem Widerstand $R_{in,i}$ 210 aus Fig.2 vergleichbar ist. Ferner ist zwischen dem ersten Eingang 202 des Komparators 201 und das positive Referenzpotential $V_{ref+}$ 205 eine Kette von Widerständen geschaltet, welche aus dem ersten Widerstand 301 $R_{a1}$ und einer Vielzahl von zweiten Widerständen 302 ($R_2$, $R_3$, ..., $R_m$, $R_{ref}$) gebildet ist. Die Funktionalität der Widerstände $R_{a1}$, $R_2$, $R_3$, ..., $R_m$, $R_{ref}$ ist mit der Funktionalität des ersten ohmschen Widerstands $R_{ref,i}$ 209 aus Fig.2 vergleichbar.

Die Eingangsspannung $V_{in}$ 207 wird gemäß Fig.3 an ein Referenzwiderstandsnetzwerk angelegt, welches Eingangsspannungen für die Komparatoren 201 generiert. Der jeweils zweite Eingang 203 der Komparatoren 201 ist auf dem elektrischen Massepotential 208. Jeder Komparator 201 arbeitet annähernd bei demselben Eingangsspannungswert und somit auf fast dem selben Arbeitspunkt. Zudem ist die Empfindlichkeit der Komparatoren 201 mittels geeigneter Wahl der Einzelwiderstände 301 bis 303 für alle Komparatoren 201 annähernd identisch.

Anschaulich wird die Eingangsspannung $V_{in}$ 207 unter Verwendung einer Längswiderstandskette aus den zweiten Widerständen $R_i$ 302 geteilt bzw. verschoben. Mittels der ersten Widerstände $R_{a,i}$ 301 und der zweiten Widerstände $R_{b,i}$ 302 kann die Empfindlichkeit der einzelne Komparatoren 201 eingestellt werden. Die Berechnung der Widerstandswerte für die ohmschen Widerstände 301 bis 303 ist bei dem Analog-Digital-Wandler 300 analytisch nicht möglich. Daher werden die Werte der ohmschen Widerstände 301 bis 303 mittels numerischen Lösens des folgenden Gleichungssystems ermittelt:

$$\frac{V_{i-1} - V_i}{R_i} + \frac{V_{i+1} - V_i}{R_{i+1}} - \frac{V_i}{R_{ai} + R_{bi}} = 0 \qquad (8)$$

und

$$\frac{V_{comp,i}}{V_i} = \frac{R_{bi}}{R_{ai} + R_{bi}} \qquad (9)$$

mit den Nebenbedingungen:

$$V_{comp,i} = 0 \text{ für } V_{in,i} = i \cdot \Delta V \text{ mit } i = -m, \ldots, 0, \ldots, m \ (2m + 1 = n) \qquad (10)$$

und

$$\frac{\partial V_{comp,i}}{\partial V_{in}} = const. \qquad \forall i \qquad (11)$$

Aufgrund der vielen Freiheitsgrade bei der numerischen Berechnung können auch noch weitere Nebenbedingungen wie der Ausgangswiderstand des Netzwerkes an den Komparatoranschlüssen berücksichtigt werden.

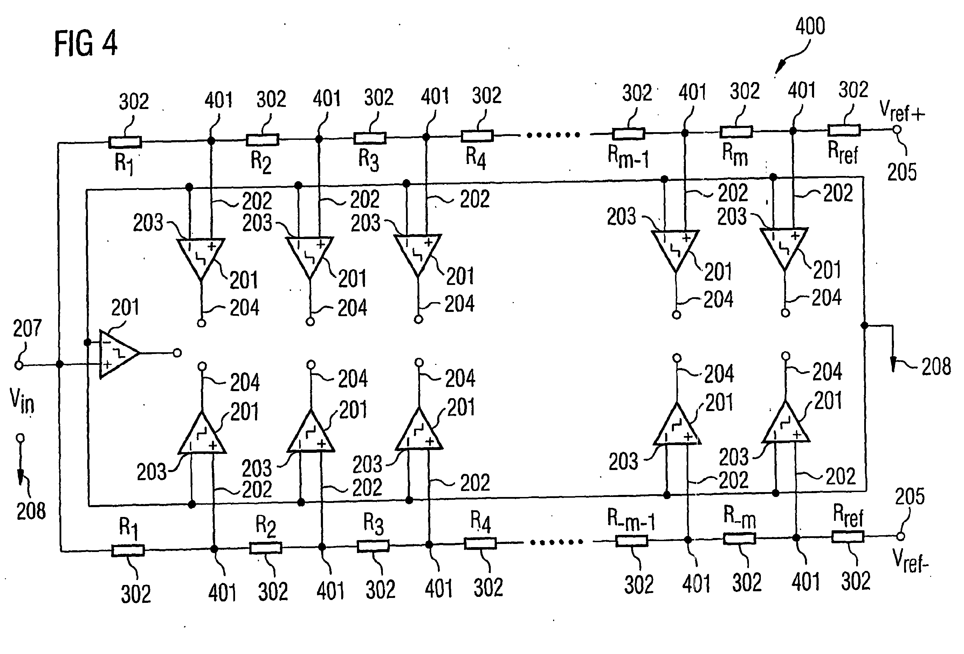

Im Weiteren wird bezugnehmend auf **Fig.4** ein Analog-Digital-Wandler 400 gemäß einem dritten Ausführungsbeispiel der Erfindung beschrieben.

Der Analog-Digital-Wandler 400 unterscheidet sich von dem in Fig.3 gezeigten Analog-Digital-Wandler 300 im Wesentlichen dadurch, dass die ersten und dritten ohmschen Widerstände 301, 303 weggelassen sind.

Folglich können die Komparatoren 201 bei dem Analog-Digital-Wandler 400 leicht unterschiedliche Empfindlichkeiten aufweisen. Allerdings ist das Widerstandsnetzwerk aus Fig.4 gegenüber Fig.3 stark vereinfacht, und eine sukzessive analytische Berechnung der Werte der Widerstände 302 ist möglich.

Für die Spannung $V_{comp,i}$ an den Knoten 401, die mit dem ersten Eingang 202 der Komparatoren 201 gekoppelt sind, gilt allgemein:

$$\frac{V_{in} - V_{comp,i}}{\sum\limits_{j=1}^{i} R_j} + \frac{V_{ref,\pm} - V_{comp,i}}{\sum\limits_{j=i+1}^{m} R_j + R_{ref}} = 0 \qquad\qquad (12)$$

Eine Nebenbedingung zum Berechnen der Widerstandswerte 302 ist $V_{comp,i}=0$ für $V_{in,i}=i\cdot_\Delta V$ mit i=-m, ..., 0, ... +m, wobei 2m+1=n. Anschaulich bedeutet dies, dass die Eingangsspannung am i-ten Komparator $V_{comp,i}$ exakt Null sein soll, wenn die Eingangsspannung einen bestimmten Wert $V_{in,j}=i\cdot_\Delta V$ aufweist.

Somit folgt aus (12):

$$\frac{i \cdot \Delta V}{\sum\limits_{j=1}^{i} R_j} + \frac{V_{ref,\pm}}{\sum\limits_{j=i+1}^{m} R_j + R_{ref}} = 0 \qquad\qquad (13)$$

$_\Delta V$ sei eine kleine Spannungsdifferenz, die in dem Analog-Digital-Wandler 400 dem Least Significant Bit (LSB) entspricht. Eine einfache Berechnung der Widerstandswerte 302 ist unter der Annahme möglich, dass das Referenzpotential $V_{ref}$ der negativen maximalen Eingangsspannung des Analog-Digital-Wandler 400 entspricht ($V_{ref+}=m\cdot_\Delta V$, $V_{ref-}=-m_\Delta V$). In diesem Fall gilt $\sum\limits_{j=1}^{m} R_j = R_{ref}$ , und aus (13) folgt:

$$\frac{i \cdot V_{ref,\pm}}{m \sum\limits_{j=i}^{i} R_j} = \frac{V_{ref,\pm}}{2R_{ref} - \sum\limits_{j=1}^{i} R_j} \qquad\qquad (14)$$

Dies lässt sich weiter vereinfachen zu:

$$R_i = \frac{2R_{ref}}{\dfrac{m}{i} + 1} - \sum\limits_{j=1}^{i-1} R_j \qquad\qquad (15)$$

Der Eingangswiderstand des Widerstandsnetzwerks aus den Widerständen 302 ergibt sich in diesem Fall zu $R_{in}=2R_{ref}/2=R_{ref}$. Dieser Wert ergibt sich mittels Parallelschaltens zweier Netzwerke (positiver und negativer Zweig) mit einem ohmschen Widerstand von jeweils $2R_{ref}$. Soll wiederum ein Eingangswiderstand von 50Ω realisiert werden, so ist demnach $R_{ref}$=5052 zu wählen.

Mittels dieser Wahl des Widerstandswerts können mittels der Formel (15) die Werte aller weiterer Widerstände sukzessive, beginnend mit $R_1$ berechnet werden.

In **Fig.6B** sind die Widerstandswerte (in Ω) für ein 6 Bit Wandler gemäß dem Ausführungsbeispiel von Fig.4 dargestellt.

Wird der Wert des Eingangswiderstands zu hoch gewählt, kann es zu dynamischen Verzerrungen im Wandlerbetrieb kommen. In diesem Falle wirkt die Kette aus Widerständen 302 und den Eingangskapazitäten der Komparatoren 201 als Tiefpass, so dass die Komparatoren 201 mit hoher Ordnungszahl, daher insbesondere der m-te Komparator, ein leicht phasenverschobenes Eingabesignal erhalten. Die ist bei dem in Fig.2 gezeigten Analog-Digital-Wandler 200 vermieden.

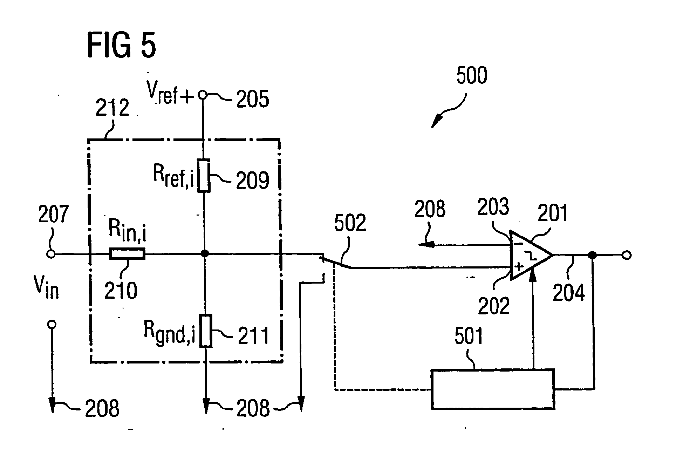

Im Weiteren wird bezugnehmend auf **Fig. 5** ein Analog-Digital-Wandler 500 gemäß einem vierten Ausführungsbeispiel der Erfindung beschrieben.

Genauer gesagt zeigt Fig.5 die Verschaltung eines Komparators 201 eines Analog-Digital-Wandlers unter Verwendung einer Kalibrier-Einrichtung 501. Somit kann aus der Verschaltung des Komparators 201 aus Fig.5 ähnlich der in Fig.2 oder Fig.3 oder Fig.4 gezeigten Weise ein Analog-Digital-Wandler mit einer Mehrzahl von Komparatoren gebildet werden.

Die in Fig.5 gezeigte Einzelstufe eines Analog-Digital-Wandlers 500 unterscheidet sich von einer Einzelstufe des Analog-Digital-Wandlers 200 aus Fig.2 im Wesentlichen dadurch, dass eine Kalibrier-Einrichtung 501 und ein Schalter 502 bereitgestellt ist. Mittels des Schalter-Elements 502 kann der erste Eingang 202 des Komparators 201 in einem Messmodus mit dem Widerstandsnetzwerk 212 gekoppelt werden (siehe die in Fig.5 gezeigte Schalterstellung des Schalters 502).

In der zu Fig.5 komplementären Stellung des Schalters 502 ist der erste Eingang 202 auf das elektrische Massepotential 208 gebracht. In dieser Stellung sind beide Eingänge 202, 203 des Komparators 201 auf dem elektrischen Massepotential 208. Basierend auf einem in diesem Szenario ermittelten Ausgabesignal des Komparators 201 an seinem Ausgang 204 regelt die Kalibrier-Einrichtung 501, der dieses, Ausgabesignal bereitgestellt ist, den Komparator 201 derart nach, dass ein möglicher Offset des Komparators dadurch ausgeglichen wird.

Komparatoren 201 können bedingt durch physikalische Effekte Abweichungen in der Lage ihrer Entscheidungsschwelle aufweisen. In einem Komparator 201, der zwei Spannungen miteinander vergleicht, wird dies in Form eines Eingangsspannungs-Offsets ausgedrückt. Diese Offset-Spannungen sind gleichverteilt und hängen von den Eigenschaften des Halbleiter-Prozesses zum Herstellen der Komparatoren 201 sowie von den Flächen aller in dem Komparator 201 verwendeten Bauelemente ab. Dabei gilt, dass die statistische Abweichung der Eingangsspannung mit zunehmender Bauteilfläche abnimmt. Bei Verwendung sehr kleinflächiger Bauteile kann dieser Effekt dazu führen, dass die Monotonizität der digitalen Signale nicht mehr gewährleistet ist. Ist der Offset eines Komparators 201 größer als der Spannungsabstand $_\Delta V$ der Schaltschwelle, so kann es vorkommen, dass bei einer bestimmten Eingangsspannung ein höherwertiger Komparator 201 bereits einen Ausgangswert mit einem logischen Wert "1" und simultan ein niederwertiger Komparator 201 einen Ausgangswert mit einem logischen Wert "0" anzeigt (oder umgekehrt). Der am Ausgang der Komparatoren 201 bereitgestellte Thermometercode ist daher unterbrochen, so dass eine aufwändige Korrektur in einer nachgeschalteten Digitallogik erforderlich sein kann. Ferner führt eine OffsetSpannung der Komparatoren zu einer Reduzierung der effektiven Auflösung des Wandlers. Aus diesen Gründen muss entweder der Offset der Komparatoren ausreichend gering gewählt werden (was einschränkende Bedingungen hinsichtlich der Bauteilflächen zur Folge hat) und/oder es kann eine Kalibrier-Einrichtung wie die in Fig.5 gezeigte Kalibrier-Einrichtung 501 bereitgestellt werden.

Da bei allen Komparatoren 201 erfindungsgemäß die Entscheidungsschwelle bei einer Eingangsspannung nahe dem Massepotential 208 liegt, kann eine Kalibrierung der Komparatoren 201 besonders einfach mittels Anlegens des Massepotentials 201 an den ersten Eingang 202 erfolgen. Dies ist in Fig.5 mittels des Schalters 502 (Halbleiterschalter/Transmission-Gate) realisiert, der den Eingang 202 des Komparators 201 zwischen der Eingangsspannung $V_{comp,i}$ und der Massespannung 208 umschaltet. Liegt ein definierter Eingangszustand vor, kann die Kalibrier-Einrichtung 501 den Komparator 201 derart justieren, dass sich dieser exakt im labilen Arbeitspunkt befindet. Diese Justierung wird gespeichert, und der Komparator 201 kann wieder im Messmodus betrieben werden. Im Gegensatz zu herkömmlichen Analog-Digital-Wandlern sind somit zur Kalibrierung des erfindungsgemäßen Analog-Digital-Wandlers 500 nicht eine Vielzahl von zusätzlichen Kalibrierspannungen erforderlich, es ist lediglich das ohnehin vorhandene Massepotential 208 an den ersten Eingang 202 der Komparatoren 201 anzulegen.

Es ist anzumerken, dass eine Kalibrierschaltung, wie die in Fig. 5 gezeigte, in jedem anderen Ausführungsbeispiel eines erfindungsgemäßen Analog-Digital-Wandlers enthalten sein kann.

Be der Kalibrier-Einrichtung des erfindungsgemäßen Analog-Digital-Wandlers 500 erfolgt somit eine sehr einfache Offset-Korrektur der Komparatoren 201, da diese annähernd bei demselben Wert der Eingangsspannung arbeiten. Jeder erste Komparatoreingang 202 wird mittels des Schalters 502 auf Massepotential 208 gelegt, das Vergleichsergebnis an Ausgang 204 wird ausgewertet, und der Komparator 201 wird mittels eines Justiereingangs 503, auf welchen die Kalibrier-Einrichtung 501 zugreift, abgeglichen.

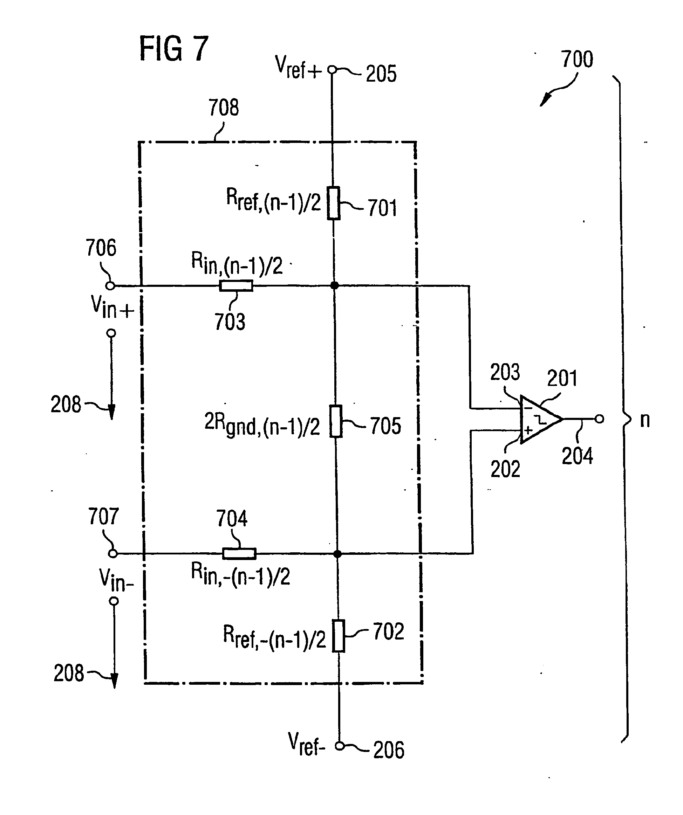

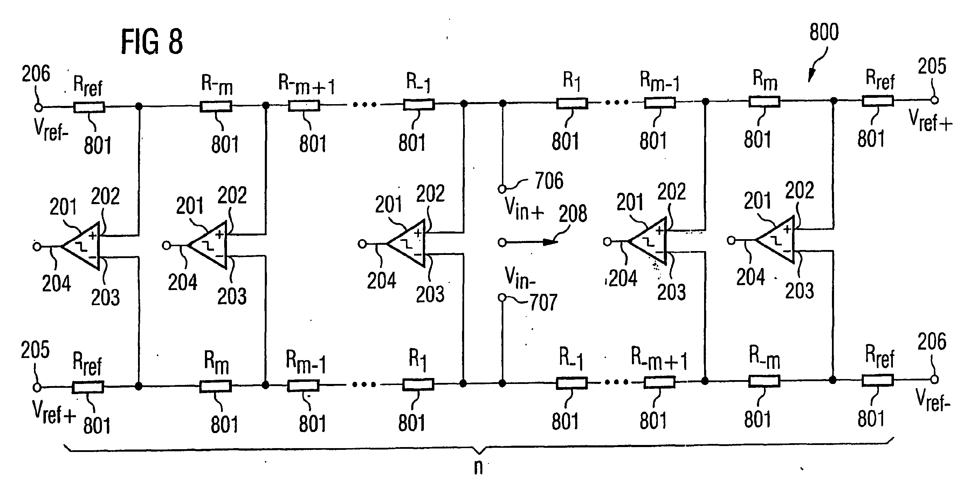

Im Weiteren werden bezugnehmend auf Fig.7 und Fig.8 zwei zusätzliche Ausführungsbeispiele von erfindungsgemäßen Analog-Digital-Wandlern beschrieben, die zur Verarbeitung eines differentiellen Eingabesignals eingerichtet sind.

Insbesondere in der Hochfrequenztechnik liegt ein Eingabesignal häufig in der Form eines differentiellen Signals vor. Zwei zueinander gegenphasige Eingangssignale $V_{in+}$ und $V_{in-}$ werden in Analog-Digital-Wandlern nach dem Stand der Technik häufig jeweils von unabhängigen Komparatoren in ein digitales Signal gewandelt und anschließend digital subtrahiert.

Die in Fig.7 und Fig.8 gezeigten erfindungsgemäßen Analog-Digital-Wandler 700, 800 eignen sich besonders gut für die Verarbeitung differentieller Signale. Dazu wird in Abweichung zu den Ausführungsbeispielen aus Fig.2 bis Fig.4 an die beiden Eingänge eines jeweiligen Komparators 201 jeweils ein verschobenes Spannungssignal $V_{comp,i+}$ aus dem positiven Zweig und das Signal $V_{comp,i-}$ aus dem negativen Zweig angelegt. Passiert die Eingangsspannung den für dieses Widerstandsnetzwerk vorgesehenen Spannungswert, so passiert die eine Eingangsspannung des Komparators das Massepotential in positiver Richtung, die andere Eingangsspannung in negativer Richtung. Mittels dieser Architektur ist der effektive Spannungshub am Komparator doppelt so hoch wie bei der nichtdifferentiellen Architektur. Aufgrund der verdoppelten Eingangsamplitude an dem Komparator verringern sich entsprechend die Anforderungen an den Eingangsspannungs-Offset der Komparatoren. Die differentielle Signalverarbeitung kann in jedem der bereits vorgestellten Ausführungsbeispiele verwirklicht werden.

Im Weiteren wird bezugnehmend auf **Fig.7** ein Analog-Digital-Wandler 700 gemäß einem fünften Ausführungsbeispiel der Erfindung beschrieben.

Wiederum ist in Fig.7 nur eine Stufe, d.h. ein Komparator und ein zugehöriges Widerstandsnetzwerk, eines Analog-Digital-Wandlers 700 gezeigt. Der in Fig.7 gezeigte Analog-Digital-Wandler 700 weist insgesamt n solcher Stufen auf.

Der Analog-Digital-Wandler 700 aus Fig.7 weist wiederum einen Komparator 201 mit einem ersten Eingang 202 und einem zweiten Eingang 203 auf, sowie mit einem Ausgang 204. Zwischen den zweiten Eingang 203 und das positive Referenzsignal $V_{ref+}$ 205 ist ein erster ohmscher Widerstand 701 $R_{ref,(n-1)/2}$ geschaltet. Zwischen den ersten Eingang 202 und das negative Referenzpotential $V_{ref-}$ 206 ist ein zweiter ohmscher Widerstand $R_{ref,-(n-1)/2}$ geschaltet. Ferner ist zwischen dem zweiten Eingang 203 und ein erstes zu digitalisierendes Teilsignal 706 $V_{in+}$, ein dritter ohmscher Widerstand $R_{in,(n-1)/2}$ geschaltet. Zwischen den zweiten Eingang 203 und ein erstes zu digitalisierendes Teilsignal 706 ist ein dritter ohmscher Widerstand $R_{in,(n-1)/2}$ 703 geschaltet. Zwischen den ersten Eingang 202 und ein zweites zu digitalisierendes Teilsignal 707 ist ein vierter ohmscher Widerstand $R_{in,-(n-1)/2}$ 704 geschaltet. Darüber hinaus ist zwischen den ersten und dem zweiten Eingang 202, 203 ein fünfter ohmscher Widerstand $2R_{gnd,(n=1)/2}$ 705 geschaltet. Der fünfte ohmsche Widerstand kann auch in zwei Teilwiderstände aufgeteilt sein, deren Mittenabgriff auf ein Referenzpotential (z.B. das elektrische Massepotential) gebracht sein kann. Die Teilsignale 706, 707 bilden ein differentielles Eingangssignal, welches von dem Komparator 201 gemeinsam verarbeitet wird. Die in Fig.7 gezeigte Stufe des Analog-Digital-Wandlers 700 stellt das Analogon zur der obersten in Fig.2 gezeigten Stufe dar. Widerstände 701 bis 705 bilden ein Widerstandsnetzwerk 708.

Die differenziellen Eingangsspannungen $V_{in+}$ 706 und $V_{in-}$ 707 werden mittels zweier Widerstandsteiler, die jedem der insgesamt n Komparatoren 201 vorgeschaltet sind, derart verschoben, dass alle Komparatoren 201 im Wesentlichen auf demselben Arbeitspunkt arbeiten können.

Im Weiteren wird bezugnehmend auf **Fig.8** ein Analog-Digital-Wandler 800 gemäß einem sechsten Ausführungsbeispiel der Erfindung beschrieben.

Analog-Digital-Wandler 800 ist zum Verarbeiten eines differentiellen Eingabesignals 706, 707 eingerichtet. Die ohmschen Widerstände 801 in Fig.8 ersetzen die ohmschen Widerstände 701 bis 705 aus Fig.7. Anschaulich werden die differenziellen Eingangsspannungen $V_{in+}$ sowie $V_{in-}$ 706, 707 gemäß Fig.8 mittels zweier Widerstandsnetzwerke (der gemäß Fig.8 oberen Kette von ohmschen Widerständen 801 bzw. der gemäß Fig.8 unteren Kette von ohmschen Widerständen 801) derart verschoben, das alle Komparatoren 201 im Wesentlichen auf demselben Arbeitspunkt arbeiten.

In diesem Dokument sind folgende Veröffentlichungen zitiert:

[1] US 6,114,982
[2] GB 2,187,054 A
[3] JP-07254857 A
[4] US 6,437,724 B1
[5] EP 0,729,233 A1

Bezugszeichenliste

| 100 | Analog-Digital-Wandler |
| 101 | Komparatoren |
| 102 | erster Eingang |
| 103 | zweiter Eingang |
| 104 | Ausgang |
| 105 | ohmsche Widerstände |
| 106 | positives Referenzpotential |
| 107 | negatives Referenzpotential |
| 108 | zu digitalisierendes Signal |
| 200 | Analog-Digital-Wandler |
| 201 | Komparatoren |
| 202 | erster Eingang |
| 203 | zweiter Eingang |
| 204 | Ausgang |
| 205 | positives Referenzpotential |
| 206 | negatives Referenzpotential |
| 207 | zu digitalisierendes Signal |
| 208 | Massepotential |
| 209 | erster ohmscher Widerstand |
| 210 | zweiter ohmscher Widerstand |
| 211 | dritter ohmscher Widerstand |
| 212 | Widerstandsnetzwerk |
| 213 | Eingangsknoten |
| 300 | Analog-Digital-Wandler |
| 301 | erster ohmscher Widerstand |
| 302 | zweiter ohmscher Widerstand |
| 303 | dritter ohmscher Widerstand |
| 400 | Analog-Digital-Wandler |
| 401 | Knoten |
| 500 | Analog-Digital-Wandler |
| 501 | Kalibrier-Einrichtung |
| 502 | Schalter |
| 503 | Justiereingang |
| 700 | Analog-Digital-Wandler |
| 701 | erster ohmscher Widerstand |
| 702 | zweiter ohmscher Widerstand |
| 703 | dritter ohmscher Widerstand |
| 704 | vierter ohmscher Widerstand |
| 705 | fünfter ohmscher Widerstand |
| 706 | erstes zu digitalisierendes Teilsignal |
| 707 | zweites zu digitalisierendes Teilsignal |
| 708 | Widerstandsnetzwerk |
| 800 | Analog-Digital-Wandler |
| 801 | ohmsche Widerstände |

**Patentansprüche**

1. Analog-Digital-Wandler zum Umwandeln eines zu digitalisierenden Signals in ein digitalisiertes Signal,
mit einer Mehrzahl von Komparatoren, von denen jeder einen ersten und einen zweiten Eingang und einen Ausgang aufweist, an welchem Ausgang das digitalisierte Signal bereitstellbar ist;
mit einem Impedanz-Netzwerk für jeden Komparator, das mit zumindest einem Eingang des Komparators gekoppelt ist, wobei ein jeweiliges Impedanz-Netzwerk zwischen den zugehörigen Komparator und das zu digitalisierende Signal geschaltet ist und zwischen den zugehörigen Komparator und ein erstes elektrisches Referenzpotential geschaltet ist;
**dadurch gekennzeichnet dass** die Impedanz-Netzwerke derart eingerichtet sind, dass die Komparatoren im Wesentlichen auf denselben Arbeitspunkt gebracht sind.

**2.** Analog-Digital-Wandler nach Anspruch 1, bei dem der zweite Eingang von zumindest einem Teil der Komparatoren auf ein zweites elektrisches Referenzpotential gebracht ist.

**3.** Analog-Digital-Wandler nach Anspruch 2, bei dem das zweite elektrische Referenzpotential das Massepotential ist.

**4.** Analog-Digital-Wandler nach Anspruch 2 oder 3, bei dem zumindest ein Teil der Impedanz-Netzwerke einen ersten ohmschen Widerstand und einen zweiten ohmschen Widerstand aufweist, wobei der erste ohmsche Widerstand zwischen den ersten Eingang von zumindest einem Teil der Komparatoren und das erste elektrische Referenzpotential geschaltet ist, und wobei der zweite ohmsche Widerstand zwischen den ersten Eingang von zumindest einem Teil der Komparatoren und das zu digitalisierende Signal geschaltet ist.

**5.** Analog-Digital-Wandler nach einem der Ansprüche 1 bis 4, bei dem zumindest ein Teil der Impedanz-Netzwerke einen Spannungsteiler aufweist.

**6.** Analog-Digital-Wandler nach Anspruch 5, bei dem der Spannungsteiler eine erste Impedanz aufweist, die zwischen den ersten Eingang und ein drittes elektrisches Referenzpotential geschaltet ist.

**7.** Analog-Digital-Wandler nach Anspruch 5 oder 6, blei dem der Spannungsteiler eine zweite Impedanz aufweist, die zwischen den ersten Eingang und das erste elektrische-Referenzpotential geschaltet ist.

**8.** Analog-Digital-Wandler nach Anspruch 6 oder 7, bei dem die erste Impedanz ein dritter ohmscher Widerstand und/ oder die zweite Impedanz ein vierter ohmscher Widerstand ist; oder die erste Impedanz eine erste Kapazität und/ oder die zweite Impedanz eine zweite Kapazität ist.

**9.** Analog-Digital-Wandler nach einem der Ansprüche 6 bis 8, bei dem das dritte elektrische Referenzpotential das elektrische Massepotential ist.

**10.** Analog-Digital-Wandler nach einem der Ansprüche 1 bis 9, bei dem das erste elektrische Referenzpotential in ein erstes Teilpotential und in ein zweites Teilpotential aufgeteilt ist, wobei für einen ersten Teil der Komparatoren zumindest ein Teil von deren Impedanz-Netzwerk zwischen den ersten Eingang und das erste Teilpotential geschaltet ist, und wobei für einen zweiten Teil der Komparatoren zumindest ein Teil von deren Impedanz- Netzwerk zwischen den ersten Eingang und das zweite Teilpotential geschaltet ist.

**11.** Analog-Digital-Wandler nach Anspruch 10, bei dem das zweite und/oder das dritte elektrische Referenzpotential einen Wert zwischen dem ersten und dem zweiten Teilpotential aufweist.

**12.** Analog-Digital-Wandler nach einem der Ansprüche 1 bis 11, bei dem für zumindest einen Teil der Komparatoren eine Kalibrier-Einrichtung vorgesehen ist, die derart eingerichtet ist, dass mit dieser eine Parameterschwankung zwischen unterschiedlichen Komparatoren korrigierbar ist.

**13.** Analog-Digital-Wandler nach Anspruch 12, bei dem die Kalibrier-Einrichtung ein Schaltelement zwischen dem ersten Eingang und dem Impedanz-Netzwerk aufweist, mittels welchem Schaltelement wahlweise
in einem Erfassmodus der erste Eingang mit dem Impedanz-Netzwerk koppelbar ist oder
in einem Kalibriermodus der erste Eingang auf ein viertes elektrisches Referenzpotential bringbar ist, wobei basierend auf einem resultierenden Signal an dem Ausgang des Komparators der Komparator mittels der Kalibrier-Einrichtung kalibrierbar ist.

**14.** Analog-Digital-Wandler nach Anspruch 13, bei dem das vierte elektrische Referenzpotential gleich dem zweiten elektrischen Referenzpotential ist.

**15.** Analog-Digital-Wandler nach einem der Ansprüche 2 bis 14, bei dem der Wert von zumindest einem der ersten bis vierten ohmschen Widerstände für zumindest einen Teil der Impedanz-Netzwerke basierend auf dem Kriterium berechnet wird, dass an einem der ersten Eingänge der Komparatoren ein Signal anliegt, das im Wesentlichen gleich dem zweiten elektrischen Referenzpotential ist.

**16.** Analog-Digital-Wandler nach einem der Ansprüche 1 bis 15, bei dem der Wert von zumindest einem der ersten bis vierten ohmschen Widerstände für zumindest einen Teil der Impedanz-Netzwerke basierend auf dem Kriterium berechnet wird, dass eine Veränderung des zu digitalisierenden Signals um einen vorgebbaren Wert für zumindest einen Teil der Komparatoren zu einer Veränderung des elektrischen Potentials an deren ersten Eingang um einen im Wesentlichen gleichen Wert führt.

17. Analog-Digital-Wandler nach einem der Ansprüche 1 bis 16, bei dem der Wert von zumindest einem der ersten bis vierten ohmschen Widerstände für zumindest einen Teil der Impedanz-Netzwerke basierend auf dem Kriterium berechnet wird, dass der ohmsche Ausgangswiderstand von zumindest einem Teil der Impedanz-Netzwerke im Wesentlichen gleich ist.

18. Analog-Digital-Wandler nach Anspruch 1, bei dem
für zumindest einen Teil der Komparatoren das jeweils zugeordnete Impedanz-Netzwerk eine mit dem ersten Eingang gekoppelte erste Impedanz-Teileinrichtung und eine mit dem
zweiten Eingang gekoppelte zweite Impedanz-Teileinrichtung aufweist,
das zu digitalisierende Signal in ein erstes und ein zweites zu digitalisierendes Teilsignal aufgeteilt ist und das erste elektrische Referenzpotential in ein erstes Teilpotential und ein zweites Teilpotential aufgeteilt ist,
die erste Impedanz-Teileinrichtung zwischen dem ersten Eingang, dem ersten zu digitalisierenden Teilsignal und dem ersten Teilpotential geschaltet ist, und die zweite Impedanz-Teileinrichtung zwischen dem zweiten Eingang, dem zweiten zu digitalisierenden Teilsignal und dem zweiten Teilpotential geschaltet ist.

19. Analog-Digital-Wandler nach Anspruch 18, bei dem das erste und das zweite zu digitalisierende Teilsignal differentielle Signale sind.

20. Analog-Digital-Wandler nach Anspruch 18 oder 19, bei dem
die ersten Impedanz-Teileinrichtungen einen ersten ohmschen Widerstand und einen zweiten ohmschen Widerstand aufweisen, wobei der erste ohmsche Widerstand zwischen den ersten Eingang und das erste elektrische Teilpotential geschaltet ist, und wobei der zweite ohmsche Widerstand zwischen den ersten Eingang und das erste zu digitalisierende Teilsignal geschaltet ist;
die zweiten Impedanz-Teileinrichtungen einen dritten ohmschen Widerstand und einen vierten ohmschen Widerstand aufweist, wobei der dritte ohmsche Widerstand zwischen den zweiten Eingang und das zweite elektrische Teilpotential geschaltet ist, und wobei der vierte ohmsche Widerstand zwischen den zweiten Eingang und das zweite zu digitalisierende Teilsignal geschaltet ist.

21. Analog-Digital-Wandler nach Anspruch 20, bei dem zwischen den ersten und den zweiten Eingang mindestens ein fünfter ohmscher Widerstand geschaltet ist.

22. Analog-Digital-Wandler nach Anspruch 21, bei dem der fünfte ohmsche Widerstand in einen ersten und in einen zweiten Teilwiderstand aufgeteilt ist, wobei ein Anschluss zwischen dem ersten und dem zweiten Teilwiderstand auf ein fünftes elektrisches Referenzpotential gebracht ist.

23. Analog-Digital-Wandler nach einem der Ansprüche 1 bis 22, eingerichtet als integrierter Schaltkreis.


**Claims**

1. An analog-to-digital converter for converting a signal to be digitized into a digitized signal
with a plurality of comparators, each of which comprising a first and a second input and an output, at which output the digitized signal can be provided;
with an impedance network for each comparator connected to at least one input of the comparator, wherein respective impedance network is connected between the associated comparator and the signal to be digitized, and between the associated comparator and a first electrical reference potential;
**characterized in that** the impedance networks are configured such that the comparators are brought essentially to the same operating point.

2. Analog-to-digital converter according to claim 1,
wherein the second input of at least partly a subset of the comparators is brought to a second electrical operating point.

3. The analog-to-digital converter according to claim 2,
wherein the second electrical reference potential is the ground potential.

**4.** Analog-to-digital converter according to claim 2 or 3,
wherein at least a subset of the impedance networks comprises a first ohmic resistance and a second ohmic resistance, wherein the first ohmic resistance is connected between the first input of at least a subset of the comparators and the first electrical reference potential, and wherein the second ohmic resistance is connected between the first input of at least a subset of the comparators and the signal to be digitized.

**5.** Analog-to-digital converter according to any of claims 1 to 4,
wherein at least a subset of the impedance networks comprises a voltage divider.

**6.** Analog-to-digital converter according to claim 5,
wherein the voltage divider comprises a first impedance which is connected between the first input and a third electrical reference potential.

**7.** Analog-to-digital converter according to claim 5 or 6,
wherein the voltage divider comprises a second impedance which is connected between the first input and the first electrical reference potential.

**8.** Analog-to-digital converter according to claim 6 or 7,
wherein the first impedance is a third ohmic resistance and/or the second impedance is a fourth ohmic resistance; or the first impedance is a first capacitance and/or the second impedance is a second capacitance.

**9.** Analog-to-digital converter according to any of claims 6 to 8,
wherein the third electrical reference potential is the electrical ground potential.

**10.** Analog-to-digital converter according to any of claims 1 to 9,
wherein the first electrical reference potential is split into a first electrical partial potential and a second electrical partial potential, wherein for a first subset of the comparators at least a subset of their impedance networks is connected between the first input and the first partial potential, and wherein for a second subset of the comparators at least a subset of their impedance network is connected between the first input and the second partial potential.

**11.** Analog-to-digital converter according to claim 10,
wherein the second and/or the third electrical reference potential has a value between the first and the second partial potential.

**12.** Analog-to-digital converter according to any of claims 1 to 11,
wherein for at least a subset of the comparators a calibrating device is provided which is configured such that a parameter fluctuation between different comparators is correctable by means of the same.

**13.** Analog-to-digital converter according to claim 12,
wherein the calibrating device comprises a switching element between the first input and the impedance network, by means of that switching elements selectively
the first input is able to be connected with the impedance network in a detection mode or
the first input is able to be taken on a forth electrical reference potential in a calibrating mode, wherein based on a resulting signal at the output of the comparator the comparator is able to be calibrated with means of the calibrating device.

**14.** Analog-to-digital converter according to claim 13,
wherein the fourth electrical reference potential is the same as the second electrical reference potential.

**15.** Analog-to-digital converter according to any of claims 2 to 14,
wherein the value of at least one of the first to fourth ohmic resistances is calculated, for at least a subset of the impedance networks, based on the criterion that a signal applies to one of the first inputs of the comparators, which is essentially the same as the second electrical reference potential.

**16.** Analog-to-digital converter according to any of claims 1 to 15,
wherein the value of at least one of the first to fourth ohmic resistances is calculated, for at least a subset of the impedance networks, based on the criterion, that an altering of the signal to be digitized by a prescribable value leads, for at least a subset of the comparators, to an alteration of the electrical potential at their first input by an essentially value.

**17.** Analog-to-digital converter according to any of claims 1 to 16,
wherein the value of at least one of the first to fourth ohmic resistances is calculated, for at least a subset of the impedance networks, based on the criterion that the ohmic output resistance of at least a subset of the impedance networks is essentially the same.

**18.** Analog-to-digital converter according to claim 1,
wherein
each associated impedance network for at least a subset of the comparators comprises a first impedance subdevice coupled with the first input and a second impedance subdevice coupled with the second input,
the signal to be digitized is split into a first and a second partial signal to be digitized and the first electrical reference potential is split into a first partial potential and a second partial potential,
the first impedance subdevice is connected between the first input, the first partial signal to be digitized and the first partial potential, and the second impedance subdevice is connected between the second entrance, the second partial signal to be digitized and the second partial potentiel.

**19.** Analog-to-digital converter according to claim 18,
wherein the first and second partial signals to be digitized are differential signals.

**20.** Analog-to-digital converter according to claim 18 or 19,
wherein
the first impedance subdevices comprise a first ohmic resistance and a second ohmic resistance, wherein the first ohmic resistance is connected between the first input and the first electrical partial potential, and wherein the second ohmic resistance is connected between the first input and the first partial signal to be digitized;
the second impedance subdevices comprise a third ohmic resistance and a fourth ohmic resistance, wherein the third ohmic resistance is connected between the second input and the second electrical partial potential, and wherein the fourth ohmic resistance is connected between the second input and the second partial signal to be digitized.

**21.** Analog-to-digital converter according to claim 20,
wherein at least a fifth ohmic resistance is connected between the first and the second inputs.

**22.** Analog-to-digital converter according to claim 21,
wherein the fifth ohmic resistance is split into a first and into a second partial resistance, wherein a connection between the first and the second partial resistance is brought to a fifth electrical reference potential.

**23.** Analog-to-digital converter according to any of claims 1 to 22, configured as integrated circuit.

**Revendications**

**1.** Convertisseur analogique-numérique pour transformer un signal à numériser en un signal numérisé,
comprenant une multiplicité de comparateurs dont chacun a une première et une deuxième entrées et une sortie, sortie à laquelle le signal numérisé est disponible ;
comprenant un réseau d'impédance pour chaque comparateur, qui est couplé à au moins une entrée du comparateur, un réseau d'impédance respectif étant monté entre le comparateur associé et le signal à numériser et entre le comparateur associé et un premier potentiel électrique de référence,
**caractérisé en ce que** les réseaux d'impédance sont tels que les comparateurs sont mis sensiblement au même point de travail.

**2.** Convertisseur analogique-numérique suivant la revendication 1, dans lequel la deuxième entrée d'au moins une partie des comparateurs est mise à un deuxième potentiel électrique de référence.

**3.** Convertisseur analogique-numérique suivant la revendication 2, dans lequel le deuxième potentiel électrique de référence est le potentiel de masse.

**4.** Convertisseur analogique-numérique suivant la revendication 2 ou 3, dans lequel au moins une partie des réseaux d'impédance a une première résistance ohmique et une deuxième résistance ohmique, la première résistance ohmique étant montée entre la première entrée d'au moins une partie des comparateurs et le premier potentiel électrique de référence et la deuxième résistance ohmique étant montée entre la première entrée d'au moins une partie des comparateurs et le signal à numériser.

5. Convertisseur analogique-numérique suivant l'une des revendications 1 à 4, dans lequel au moins une partie des réseaux d'impédance a un diviseur de tension.

6. Convertisseur analogique-numérique suivant la revendication 5, dans lequel le diviseur de tension a une première impédance, qui est montée entre la première entrée et un troisième potentiel électrique de référence.

7. Convertisseur analogique-numérique suivant la revendication 5 ou 6, dans lequel le diviseur de tension a une deuxième impédance, qui est montée entre la première entrée et le premier potentiel électrique de référence.

8. Convertisseur analogique-numérique suivant la revendication 6 ou 7, dans lequel la première impédance a une troisième résistance ohmique et/ou la deuxième impédance a une quatrième résistance ohmique ; ou la première impédance est une première capacité et/ou la deuxième impédance est une deuxième capacité.

9. Convertisseur analogique-numérique suivant l'une des revendications 6 à 8, dans lequel le troisième potentiel électrique de référence est le potentiel électrique de masse.

10. Convertisseur analogique-numérique suivant l'une des revendications 1 à 9, dans lequel le premier potentiel électrique de référence est subdivisé en un premier sous potentiel et en un deuxième sous potentiel, dans lequel, pour une première partie des comparateurs, au moins une partie de leurs réseaux d'impédance est montée entre la première entrée et le premier sous potentiel et dans lequel, pour une deuxième partie des comparateurs, au moins une partie de leurs réseaux d'impédance est montée entre la première entrée et le deuxième sous potentiel.

11. Convertisseur analogique-numérique suivant la revendication 10, dans lequel le deuxième et/ou le troisième potentiel électrique de référence a une valeur comprise entre le premier et le deuxième sous potentiel.

12. Convertisseur analogique-numérique suivant l'une des revendications 1 à 11, dans lequel, pour au moins une partie des comparateurs, est prévu un dispositif d'étalonnage, qui est tel que par lui on peut corriger une fluctuation de paramètres entre des comparateurs différents.

13. Convertisseur analogique-numérique suivant la revendication 12, dans lequel le dispositif d'étalonnage a un élément de commutation entre la première entrée et le réseau d'impédance, élément de commutation au moyen duquel on peut au choix
coupler dans un mode de détection la première entrée au premier réseau d'impédance ou
mettre dans un mode d'étalonnage la première entrée sur un quatrième potentiel électrique de référence, dans lequel, sur la base d'un signal résultant à la sortie du comparateur, le comparateur peut être étalonné au moyen du dispositif d'étalonnage.

14. Convertisseur analogique-numérique suivant la revendication 13, dans lequel le quatrième potentiel électrique de référence est égal au deuxième potentiel électrique de référence.

15. Convertisseur analogique-numérique suivant l'une des revendications 2 à 14, dans lequel la valeur d'au moins l'une des première à quatrième résistances ohmiques, pour au moins une partie des réseaux d'impédance, est calculée sur la base du critère suivant lequel il est appliqué à l'une des premières entrées des comparateurs un signal, qui est sensiblement égal au deuxième potentiel électrique de référence.

16. Convertisseur analogique-numérique suivant l'une des revendications 1 à 15, dans lequel la valeur de la au moins une des première à quatrième résistances ohmiques, pour au moins une partie des réseaux d'impédance, est calculée sur la base du critère suivant lequel une modification du signal à numériser d'une valeur pouvant être prescrite pour au moins une partie des comparateurs entraîne une modification du potentiel électrique d'une valeur sensiblement égale à leur première entrée.

17. Convertisseur analogique-numérique suivant l'une des revendications 1 à 16, dans lequel la valeur de au moins une des première à quatrième résistances ohmiques, pour au moins une partie des réseaux d'impédance, est calculée sur la base du critère suivant lequel la résistance ohmique de sortie d'au moins une partie des réseaux d'impédance est sensiblement la même.

18. Convertisseur analogique-numérique suivant la revendication 1, dans lequel, pour au moins une partie des comparateurs, le réseau d'impédance respectivement associé a un premier sous dispositif d'impédance couplé à la première entrée et un deuxième sous dispositif d'impédance couplé à la deuxième entrée,
le signal à numériser est subdivisé en un premier et en un deuxième sous signal à numériser et le premier potentiel électrique de référence est subdivisé en un premier sous potentiel et en un deuxième sous potentiel,
le premier sous dispositif d'impédance est monté entre la première entrée, le premier sous signal à numériser et le premier sous potentiel et le deuxième sous dispositif d'impédance est monté entre la deuxième entrée, le deuxième sous signal à numériser et le deuxième sous potentiel.

19. Convertisseur analogique-numérique suivant la revendication 18, dans lequel le premier et le deuxième sous signal à numériser sont des signaux différentiels.

20. Convertisseur analogique-numérique suivant la revendication 18 ou 19, dans lequel les premiers sous dispositifs d'impédance ont une première résistance ohmique et une deuxième résistance ohmique, dans lequel la première résistance ohmique est montée entre la première entrée et le premier sous potentiel électrique et dans lequel la deuxième résistance ohmique est montée entre la première entrée et le premier sous signal à numériser ;
les deuxièmes sous dispositifs d'impédance ont une troisième résistance ohmique et une quatrième résistance ohmique, dans lequel la troisième résistance ohmique est montée entre la deuxième entrée et le deuxième sous potentiel électrique et dans lequel la quatrième résistance ohmique est montée entre la deuxième entrée et le deuxième sous signal à numériser.

21. Convertisseur analogique-numérique suivant la revendication 20, dans lequel au moins une cinquième résistance ohmique est montée entre la première et la deuxième entrée.

22. Convertisseur analogique-numérique suivant la revendication 21, dans lequel la cinquième résistance ohmique est subdivisée en une première et en une deuxième sous résistances, une borne entre la première et la deuxième sous résistance étant mise à un cinquième potentiel électrique de référence.

23. Convertisseur analogique-numérique suivant l'une des revendications 1 à 22 sous la forme d'un circuit intégré.

# FIG 1 Stand der Technik

# FIG 2A

$V_{ref+}$ ○ ~205

212

200

$R_{ref,(n-1)/2}$ ~209

208  203  201

$R_{in,(n-1)/2}$

210  213  204

202

$R_{gnd,(n-1)/2}$ ~211

~208

$V_{ref+}$ ○ ~205

$R_{ref,1}$ ~209

208  203  201

$R_{in,1}$

210  213  204

202

$R_{gnd,1}$ ~211

~208

208  203  201

$R_{in,0}$

210  213  202  204

$R_{gnd,0}$ ~211

~208

# FIG 2B

$V_{in}$

207

208

200

$V_{ref-}$ 206

$R_{ref,-1}$ 209

208 203 201

$R_{in,-1}$

210

213

$R_{gnd,-1}$ 211

208

202 204

208

$V_{ref-}$ 206

$R_{ref,-(n-1)/2}$ 209

208 203 201

$R_{in,-(n-1)/2}$

210

213

$R_{gnd,-(n-1)/2}$ 211

202 204

208

FIG 3

FIG 4

EP 1 565 991 B1

## FIG 5

## FIG 6A

|   | Rin: | 1600 |
|---|---|---|
| i | Rgndi | Rrefi |
| 1 | 1653 | 49600 |
| 2 | 1710 | 24800 |
| 3 | 1771 | 16533 |
| 4 | 1837 | 12400 |
| 5 | 1908 | 9920 |
| 6 | 1984 | 8267 |
| 7 | 2067 | 7086 |
| 8 | 2157 | 6200 |
| 9 | 2255 | 5511 |
| 10 | 2362 | 4960 |
| 11 | 2480 | 4509 |
| 12 | 2611 | 4133 |
| 13 | 2756 | 3815 |
| 14 | 2918 | 3543 |
| 15 | 3100 | 3307 |
| 16 | 3307 | 3100 |
| 17 | 3543 | 2918 |
| 18 | 3815 | 2756 |
| 19 | 4133 | 2611 |
| 20 | 4509 | 2480 |
| 21 | 4960 | 2362 |
| 22 | 5511 | 2255 |
| 23 | 6200 | 2157 |
| 24 | 7086 | 2067 |
| 25 | 8267 | 1984 |
| 26 | 9920 | 1908 |
| 27 | 12400 | 1837 |
| 28 | 16533 | 1771 |
| 29 | 24800 | 1710 |
| 30 | 49600 | 1653 |
| 31 |  | 1600 |

## FIG 6B

| Rref: | 50 |
|---|---|
| i | Ri |
| 1 | 3,125 |
| 2 | 2,936 |
| 3 | 2,763 |
| 4 | 2,605 |
| 5 | 2,460 |
| 6 | 2,327 |
| 7 | 2,205 |
| 8 | 2,092 |
| 9 | 1,987 |
| 10 | 1,890 |
| 11 | 1,800 |
| 12 | 1,717 |
| 13 | 1,638 |
| 14 | 1,566 |
| 15 | 1,498 |
| 16 | 1,434 |
| 17 | 1,374 |
| 18 | 1,318 |
| 19 | 1,265 |
| 20 | 1,216 |
| 21 | 1,169 |
| 22 | 1,125 |
| 23 | 1,083 |
| 24 | 1,044 |
| 25 | 1,006 |
| 26 | 0,971 |
| 27 | 0,938 |
| 28 | 0,906 |
| 29 | 0,876 |
| 30 | 0,847 |
| 31 | 0,820 |

# FIG 7

$V_{ref+}$ o— 205

708

$R_{ref,(n-1)/2}$ ⊓ —701

706

$R_{in,(n-1)/2}$

703

$V_{in+}$ o

208 →

$2R_{gnd,(n-1)/2}$ ⊓ —705

203   201

—

+

204

202

n

707   704

$R_{in,-(n-1)/2}$

$V_{in-}$ o

208 →

$R_{ref,-(n-1)/2}$ ⊓ —702

$V_{ref-}$ o— 206

700

FIG 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6114982 A
- GB 2187054 A
- JP 07254857 A
- US 6437724 B1
- EP 0729233 A1